# EUROPEAN PATENT SPECIFICATION

(11) **EP 4 614 015 B1**
(45) Date of publication and mention of the grant of the patent: **07.10.2026**
(21) Application number: 23902167.8
(22) Date of filing: 24.08.2023
(51) Int. Cl.: H04M 1/02, G06F 1/16, H05K 5/02

(54) **ROTATING MECHANISM AND FOLDING TERMINAL**
DREHMECHANISMUS UND KLAPPENDGERÄT
MÉCANISME ROTATIF ET TERMINAL PLIANT

(30) Priority: 13.12.2022 CN 202211601254
(43) Date of publication of application: 10.09.2025
(73) Proprietor: Honor Device Co., Ltd., Shenzhen, Guangdong 518040 (CN)
(72) Inventor: GAO, Mingqian, Shenzhen, Guangdong 518040 (CN); WANG, Yuan, Shenzhen, Guangdong 518040 (CN); GE, Linfeng, Shenzhen, Guangdong 518040 (CN)
(74) Representative: Gill Jennings & Every LLP
(86) International application number: PCT/CN2023/114713
(87) International publication number: WO 2024/124958

(56) References cited:
- CN-A- 113 194 183
- CN-A- 114 726 940
- CN-A- 114 909 388
- CN-A- 115 217 838
- CN-A- 115 388 085
- CN-U- 212 509 197
- CN-U- 219 262 955
- US-A1- 2019 394 894
- US-A1- 2021 181 808
- US-A1- 2024 206 093

## Description

### TECHNICAL FIELD

This application relates to the field of electronic device technologies, and in particular, to a rotary mechanism and a foldable terminal.

### BACKGROUND

With the increase of people's demand, foldable terminals are more and more concerned and favored by people. In a foldable terminal, usually a rotary mechanism is utilized to drive the bodies on both sides to rotate synchronously in opposite directions, to switch between a folded state and an unfolded state, so as to improve functional requirements such as visual display and an inner screen of the foldable screen. However, the existing rotary mechanism has a complex structure and cannot be fully placed in a limited and narrow space, and as a result, the size and thickness of the entire machine cannot be further reduced and thinned. Therefore, the appearance of the mobile phone is affected.

CN115388085A describes a folding device for an electronic equipment and an electronic equipment including the folding device. US2021/181808A1 describes a hinge and a mobile terminal, where the hinge does not compress a flexible display during folding, so that a sufficient accommodation space is provided for the flexible display, a thickness of the mobile terminal does not increase after being folded, and no large gap is formed. CN115217838A describes a folding apparatus and an electronic device, to reduce pulling or squeezing caused to a flexible display in a folding process.

### SUMMARY

To solve the problem that the rotary mechanism has a complex structure and cannot be fully placed in a limited and narrow space, and as a result, the size and thickness of the entire machine cannot be further reduced and thinned, this application provides a rotary mechanism and a foldable terminal having a relatively simple structure. The scope of the invention is set out in the appended claims.

A first aspect of this application provides a rotary mechanism. The rotary mechanism includes a first swing arm provided with a first rotary seat, a second swing arm provided with a second rotary seat, and a gear set. The first swing arm is rotatable about a first axis, the second swing arm is rotatable about a second axis, and the second axis is parallel to the first axis. The first rotary seat is provided with a plurality of first gear teeth distributed in a circumferential direction, the second rotary seat is provided with a plurality of second gear teeth distributed in a circumferential direction, and the plurality of first gear teeth and the plurality of second gear teeth are meshed and connected through the gear set, to enable the first swing arm and the second swing arm to rotate synchronously and reversely.

It may be understood that the rotary mechanism may be applied to a foldable terminal, and foldable terminal may be a foldable mobile phone, a tablet computer (tablet personal computer), an e-book reader, a laptop computer (laptop computer), a personal digital assistant (personal digital assistant, PDA), a personal computer, a notebook computer (notebook), an onboard device, a wearable device (for example, a watch), a box, and other electronic devices that need synchronous opening and closing.

That is, in the embodiments of this application, the first swing arm and the second swing arm are each integrated with a gear teeth structure, and the gear teeth on the first swing arm and the second swing arm are meshed through the gear set, to enable the first swing arm and the second swing arm to rotate synchronously and reversely. Specifically, the first axis and the second axis extend in a direction Z mentioned in the following embodiments, the first swing arm rotates in a direction A mentioned in the following embodiments, and the second swing arm rotates in a direction B mentioned in the following embodiments. For example, the first swing arm and the second swing arm are arranged side by side in a first direction (for example, the first direction may be a direction X mentioned in the following embodiments). The gear set includes a plurality of intermeshing gears (optionally, the gear set may include an even number of gear teeth in meshing connection), and the gears are arranged between the first gear teeth on the first swing arm and the second gear teeth on the second swing arm in the first direction, to enable the first swing arm and the second swing arm to rotate synchronously and reversely.

For the rotary mechanism, the structure of the rotary mechanism is simplified by providing a gear teeth structure on each of the first swing arm and the second swing arm and utilizing the gear set to mesh and connect the gear teeth on the two swing arms, so that the rotary mechanism can be fully placed in a narrow space in a casing, which is conducive to implementing reduction and thinning of the size of a foldable machine, and is conducive to the compactness of a foldable terminal. In addition, the rotary mechanism has a simple and compact structure, a low cost, and a large application range.

In some possible implementations of the first aspect, a part of the first rotary seat extending in the circumferential direction is provided with the plurality of first gear teeth, and a part of the second rotary seat extending in the circumferential direction is provided with the plurality of second gear teeth. The circumferential direction is a direction around a circumferential surface of a rotary seat, that is, a direction C mentioned in the following embodiments. Gear teeth are provided on part of the circumferential surfaces of the first rotary seat and the second rotary seat in the direction C mentioned in the following embodiments. For example, the circumferential surfaces of the first rotary seat and the second rotary seat are 360°, and the gear teeth are arranged on opposite semi-circumferential surfaces of the first rotary seat and the second rotary seat (that is, 180° circumferential surfaces exactly opposite to each other). By using the method, the size of the rotary mechanism can be further reduced while ensuring that the rotary mechanism can implement a synchronous rotation function.

In some possible implementations of the first aspect, the gear set includes a first gear and a second gear, the first gear is separately meshed with the first gear teeth and the second gear, and the second gear is separately meshed with the first gear and the second gear teeth.

That is, in this embodiment of this application, the first gear and the second gear are arranged between the first gear teeth and the second gear teeth in the direction X in the following embodiments, so that the first swing arm and the second swing arm are meshed and connected through the first gear and the second gear, thereby further ensuring synchronous and reverse rotation of the first swing arm and the second swing arm.

In some possible implementations of the first aspect, the rotary mechanism further includes a first rotary shaft, and the first axis is an axis of the first rotary shaft;
the first rotary seat includes a first shaft hole, the first shaft hole includes a first part and a second part in an axial direction, the first part of the first shaft hole is arranged corresponding to the first gear teeth, and an aperture of the first part of the first shaft hole is smaller than an aperture of the second part of the first shaft hole; and
the first rotary shaft includes a first part and a second part, a diameter of the first part of the first rotary shaft is smaller than a diameter of the second part of the first rotary shaft, the first part of the first shaft hole is sleeved on the first part of the first rotary shaft, and the second part of the first shaft hole is sleeved on the second part of the first rotary shaft.

That is, in this embodiment of this application, the first rotary seat is provided with a first shaft hole in the direction Z mentioned below, and the first shaft hole is a stepped hole in the direction Z. The first gear teeth surround an outer circumference of the first part having a small aperture in the first shaft hole, that is, an aperture inside the first gear teeth is smaller than an aperture of another part of the first rotary seat, and the corresponding first rotary shaft is also disposed in a form of a stepped shaft, so that the overall strength of the first swing arm can be ensured while ensuring the small size of the gear teeth, and the first swing arm is prevented from being partially broken.

In addition, the axial direction is the direction Z mentioned in the following embodiments, and the axial direction may be a width direction of the foldable terminal. Compared with the second part having a large aperture, the first part having a small aperture in the first shaft hole and the first part having a small diameter in the first rotary shaft are closer to middle frames at two ends of the foldable terminal in the width direction.

That is, when the size of the foldable machine is made thin, the diameter of the gear teeth are reduced correspondingly. After a stepped hole and a stepped shaft are added, the thickness of a part of the first gear teeth is increased correspondingly, and the diameter of the first rotary shaft is reduced correspondingly, so that the strength of the parts can be balanced and the reliability of the foldable terminal is ensured. Further challenge can be implemented in aspect of the size of the foldable terminal, so that the foldable terminal can be made lighter and thinner.

In some possible implementations of the first aspect, the rotary mechanism further includes a second rotary shaft, and the second axis is an axis of the second rotary shaft;
the second rotary seat includes a second shaft hole, the second shaft hole includes a first part and a second part in an axial direction, the first part of the second shaft hole is arranged corresponding to the second gear teeth, and an aperture of the first part of the second shaft hole is smaller than an aperture of the second part of the second shaft hole; and
the second rotary shaft includes a first part and a second part, a diameter of the first part of the second rotary shaft is smaller than a diameter of the second part of the second rotary shaft, the first part of the second shaft hole is sleeved on the first part of the second rotary shaft, and the second part of the second shaft hole is sleeved on the second part of the second rotary shaft.

That is, in this embodiment of this application, the second rotary seat is provided with a second shaft hole in the direction Z mentioned below, and the second shaft hole is a stepped hole in the direction Z. The second gear teeth surround an outer circumference of the first part having a small aperture in the second shaft hole, that is, an aperture inside the second gear teeth is smaller than an aperture of another part of the second rotary seat, and the corresponding second rotary shaft is also disposed in a form of a stepped shaft, so that the overall strength of the second swing arm can be ensured while ensuring the small size of the second gear teeth, and the second swing arm is prevented from being partially broken.

In addition, the axial direction is the direction Z mentioned in the following embodiments, and the axial direction may be a width direction of the foldable terminal. Compared with the second part having a large aperture, the first part having a small aperture in the second shaft hole and the first part having a small diameter in the second shaft hole are closer to middle frames at two ends of the foldable terminal in the width direction.

Based on this, when the size of the foldable terminal is made thin, the diameter of the second gear teeth is reduced correspondingly. After a stepped hole and a stepped shaft are added, the thickness of a part of the second gear teeth is increased correspondingly, and the diameter of the second rotary shaft is reduced correspondingly, so that the strength of the parts is balanced, and the reliability of the foldable terminal is ensured. Further challenge can be implemented in aspect of the size of the foldable terminal, so that the foldable terminal can be made lighter and thinner.

In some possible implementations of the first aspect, the rotary mechanism further includes a first rotary shaft, and the first axis is an axis of the first rotary shaft; one end of the first rotary seat is provided with a first rotating shaft integrally formed with the first rotary seat, and the other end of the first rotary seat is fixedly connected to the first rotary shaft; and/or, the rotary mechanism further includes a second rotary shaft, and the second axis is an axis of the second rotary shaft; and one end of the second rotary seat is provided with a second rotating shaft integrally formed with the second rotary seat, and the other end of the second rotary seat is fixedly connected to the second rotary shaft.

Specifically, fixing between the first rotary shaft and the other end of the first rotary seat and between the second rotary shaft and the other end of the second rotary seat may be implemented through a method such as threaded connection and spot welding.

Based on this, after the first rotary shaft (the second rotary shaft) and the first swing arm (the second swing arm) are integrated, the strength of the parts can be ensured, and the reliability of the foldable terminal can be ensured. Further challenge can be implemented in aspect of the size of the foldable terminal, so that the foldable terminal can be made lighter and thinner.

In some possible implementations of the first aspect, the rotary mechanism further includes a first support frame, the first support frame extends in a first direction, the first direction is perpendicular to the first axis, and two ends of the first support frame in the first direction are rotatably connected to the first rotating shaft and the second rotating shaft, respectively.

Specifically, in the axial direction (that is, in the direction Z mentioned in the following embodiments), the first support frames are disposed on one sides of the first rotary seat and the second rotary seat close to the middle frame of the foldable terminal. In addition, the first support frame extends in the direction X mentioned in the following embodiments, and two ends of the first support frame are rotatably connected to the first rotating shaft on the first rotary seat and the second rotating shaft on second rotary seat, respectively. Further, The rotating shaft on the same side of the gear set is also rotatably connected to the first support frame. That is, the first support frame provides a support point for the rotating shaft on each rotary seat and the rotating shaft on the same side of the gear set, so as to facilitate rotation of the rotary seat and the gear set.

In some possible implementations of the first aspect, two ends of the first rotary seat are each provided with a first rotating shaft integrally formed with the first rotary seat, and two ends of the second rotary seat are each provided with a second rotating shaft integrally formed with the second rotary seat;
the rotary mechanism further includes a first rotary shaft, a second rotary shaft, a first support frame, and a second support frame; the first rotary seat, the second rotary seat, and the gear set are arranged between the first support frame and the second support frame; the first support frame and the second support frame extend in a first direction, the first direction is perpendicular to the first axis, the first axis is an axis of the first rotary shaft, and the second axis is an axis of the second rotary shaft;
two ends of the first support frame in the first direction are rotatably connected to the first rotating shaft at one end of the first rotary seat and the second rotating shaft at one end of the second rotary seat, respectively; and
two ends of the second support frame in the first direction are provided with a first through hole and a second through hole, respectively, the first rotating shaft at the other end of the first rotary seat and one end of the first rotary shaft are disposed in the first through hole, and the second rotating shaft at the other end of the second rotary seat and one end of the second rotary shaft are disposed in the second through hole.

Specifically, by disposing rotating shafts at two ends of each rotary seat, the entire first rotary shaft or the second rotary shaft is not necessarily integrated with the first/second swing arm, and normal rotation of the first/second swing arm can also be ensured, thereby improving the production efficiency. In addition, the rotating shafts are added at two ends of each rotary seat, and the first/second rotary shaft does not need to pass through the rotary seat, so that the strength of the parts can be ensured and further the reliability of the foldable terminal is ensured. Further challenge can be implemented in aspect of the size of the foldable terminal, so that the foldable terminal can be made lighter and thinner.

In some possible implementations of the first aspect, two first cams are arranged on the first swing arm at an interval in an axial direction, two second cams are arranged on the second swing arm at an interval in the axial direction, and the first cams and the second cams are arranged correspondingly;
a first cam bracket and a second cam bracket are arranged at an interval in the axial direction between the two first cams, the first cam bracket and the second cam bracket both extend in a first direction, and the first direction is perpendicular to the first axis;
one end of the first cam bracket and one end of the second cam bracket are respectively in concave-convex fit with the corresponding first cams, and the other end of the first cam bracket and the other end of the second cam bracket are respectively in concave-convex fit with the corresponding second cams;
the rotary mechanism further includes a first rotary shaft and a second rotary shaft, the first axis is an axis of the first rotary shaft, and the second axis is an axis of the second rotary shaft; one end of the first rotary shaft is connected to the first rotary seat, and the other end of the first rotary shaft passes through the first cams, one end of the first cam bracket, and one end of the second cam bracket; one end of the second rotary shaft is connected to the second rotary seat, and the other end of the second rotary shaft passes through the second cams, the other end of the first cam bracket, and the other end of the second cam bracket; springs are sleeved on both the first rotary shaft and the second rotary shaft, and the springs are located between the first cam bracket and the second cam bracket.

Specifically, two cams are arranged on each swing arm at an interval, and the first/second cam bracket is provided to be in concave-convex fit with the cams; the springs are arranged between the first cam bracket and the second cam bracket, so that in a synchronous rotation process of the first swing arm and the second swing arm, the springs provide a rotation damping force of the first/second swing arm through the cams, and because two ends of the springs are limited by the cams on the first/second swing arm, no circlip brackets need to be additionally provided, and further the space of the foldable terminal in the axial direction (width direction) is saved.

In some possible implementations of the first aspect, the first swing arm is provided with first cams, the second swing arm is provided with second cams, and the first cams and the second cams are arranged correspondingly;
the rotary mechanism further includes a first rotary shaft, a second rotary shaft, a cam bracket, and a third support frame, both the cam bracket and the third support frame extend in a first direction and are arranged at an interval in an axial direction, and the first direction is perpendicular to the axial direction;
one end of the cam bracket is in concave-convex fit with the first cam, the other end of the cam bracket is in concave-convex fit with the second cam, a side of the third support frame away from the cam bracket in the axial direction is provided with a circlip bracket, and the circlip bracket extends in the first direction;
one end of the first rotary shaft is connected to the first rotary seat, and the other end of the first rotary shaft sequentially passes through the first cam, one end of the cam bracket, one end of the third support frame, and one end of the circlip bracket;
one end of the second rotary shaft is connected to the second rotary seat, and the other end of the second rotary shaft passes through the second cam, the other end of the cam bracket, the other end of the third support frame, and the other end of the circlip bracket; and
springs are sleeved on both the first rotary shaft and the second rotary shaft, and the springs are located between the cam bracket and the third support frame.

In some possible implementation manners of the first aspect, the rotary mechanism further includes a first fixing bracket, one end of the gear set being rotatably connected to the first fixing bracket.

Specifically, the rotary frame further includes a first support frame, the first support frame and the first fixing bracket are spaced apart on two sides of the gear set in the axial direction (that is, the direction Z mentioned in the following embodiments), the second end of the gear set in the axial direction is rotatably connected to the first fixing bracket, and the first end of the gear set in the axial direction and the end portion of the first/second rotary shaft on the same side (or the rotating shafts on the end portions of the first/second rotary seat) are rotatably connected to the first support frame, to enable the first swing arm and the second swing arm to rotate around the first axis and the second axis, respectively. Further, the first fixing bracket extends in the first direction, and the first rotary shaft and the second rotary shaft are fixedly connected to the first fixing bracket, separately.

A second aspect of this application provides a foldable terminal. The foldable terminal includes a first body, a second body, and any rotary mechanism in the first aspect and the possible implementations of the first aspect. The first swing arm in the rotary mechanism is connected to the first body, and the second swing arm in the rotary mechanism is connected to the second body.

In some possible implementations of the second aspect, the foldable terminal further includes a flexible screen. The flexible screen covers the first body, the second body, and the rotary mechanism. The first body and the second body rotate relative to each other through the rotary mechanism, and can drive the flexible screen to move, to enable the flexible screen to present a bent state or an unfolded state, so that the foldable terminal is switched between the folded state and the unfolded state.

### BRIEF DESCRIPTION OF DRAWINGS

FIG. 1A is a first schematic diagram of a foldable mobile phone in an unfolded state according to an embodiment of this application;
FIG. 1B is a second schematic diagram of a foldable mobile phone in an unfolded state according to an embodiment of this application;
FIG. 1C is a schematic diagram of a foldable mobile phone in a folded state according to an embodiment of this application;
FIG. 2A is a schematic diagram of a three-dimensional structure of a rotary mechanism according to Embodiment 1 of this application;
FIG. 2B is a top view of the rotary mechanism according to Embodiment 1 of this application;
FIG. 2C is a side view of the rotary mechanism according to Embodiment 1 of this application;
FIG. 3A and FIG. 3B are schematic diagrams of a three-dimensional structure of a first swing arm at two different angles according to Embodiment 1 of this application;
FIG. 4A is a top view of the first swing arm according to Embodiment 1 of this application;
FIG. 4B is a side view of the first swing arm according to Embodiment 1 of this application;
FIG. 5 is a cross-sectional view of FIG. 4A along a line D-D;
FIG. 6 is a schematic diagram of a three-dimensional structure of the first rotary shaft according to Embodiment 1 of this application;
FIG. 7 is a cross-sectional view of the first swing arm and the first rotary shaft after being assembled according to Embodiment 1 of this application;
FIG. 8 is a schematic diagram of a three-dimensional structure of a rotary mechanism according to Embodiment 2 of this application;
FIG. 9 is a top view of the rotary mechanism according to Embodiment 2 of this application;
FIG. 10A and FIG. 10B are schematic diagrams of a three-dimensional structure of a first swing arm at two different angles according to Embodiment 2 of this application;
FIG. 11 is a top view of the first swing arm according to Embodiment 2 of this application;
FIG. 12 is a cross-sectional view of FIG. 11 along a line E-E;
FIG. 13 is a schematic diagram of a three-dimensional structure of a first rotary shaft according to Embodiment 2 of this application;
FIG. 14 is a schematic diagram of a three-dimensional structure of a rotary mechanism according to Embodiment 3 of this application;
FIG. 15 is a top view of the rotary mechanism according to Embodiment 3 of this application;
FIG. 16A and FIG. 16B are schematic diagrams of a three-dimensional structure of a first swing arm at two different angles according to Embodiment 3 of this application;
FIG. 17 is a top view of the first swing arm and the second rotary shaft after being assembled according to Embodiment 3 of this application;
FIG. 18 is a cross-sectional view of FIG. 17 along a line F-F;
FIG. 19 is a schematic diagram of a three-dimensional structure of a rotary mechanism according to Embodiment 4 of this application;
FIG. 20 is a top view of the rotary mechanism according to Embodiment 4 of this application; and
FIG. 21A and FIG. 21B are schematic diagrams of a three-dimensional structure of a first swing arm at two different angles according to Embodiment 4 of this application.

Reference numerals: 1-foldable mobile phone; 100-rotary mechanism; 110-first swing arm; 111-first rotary seat; 1111-first gear teeth; 1112-first shaft hole; 11121-first part of the first shaft hole; 11122-second part of the first shaft hole; 1112a-first shaft hole; 1113-pin hole; 1114-first rotating shaft; 112-first cam; 113-first swing arm body; 120-second swing arm; 121-second rotary seat; 1211-second gear teeth; 130-gear set; 131-first gear; 132-second gear; 141-first rotary shaft; 1411-first part of the first rotary shaft; 1412-second part of the first rotary shaft; 1413-stuck cap; 1414-threaded structure; 142-second rotary shaft; 151-first cam bracket; 152-second cam bracket; 160-spring; 171-first fixing bracket; 172-second fixing bracket; 181-first support frame; 182-third support frame; 183-second support frame; 190-circlip bracket; 200-first body; 300-second body; and 400-flexible screen.

### DESCRIPTION OF EMBODIMENTS

Specific embodiments of this application will be described in detail with reference to the accompanying drawings below.

This application provides a rotary mechanism. The rotary mechanism may be applied to a foldable terminal. Specifically, the foldable terminal includes, but is not limited to, an electronic device such as a foldable mobile phone, a tablet computer (tablet personal computer), a laptop computer (laptop computer), a personal digital assistant (personal digital assistant, PDA), a personal computer, a notebook computer (notebook), an onboard device, or a wearable device (for example, a watch).

For convenience of description, for example, the foldable terminal is a foldable mobile phone for description. The following specifically describes the foldable mobile phone of this application with specific embodiments.

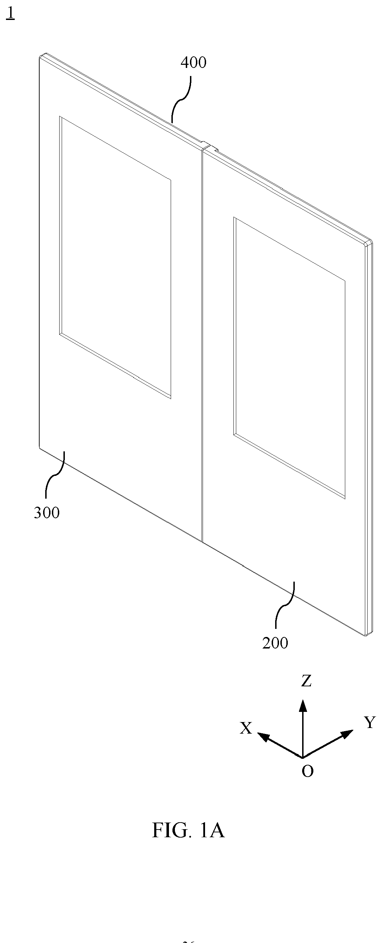

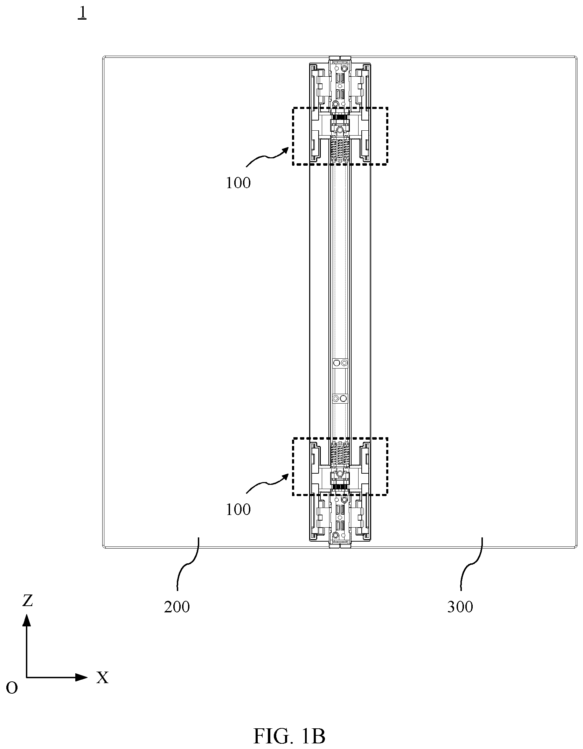

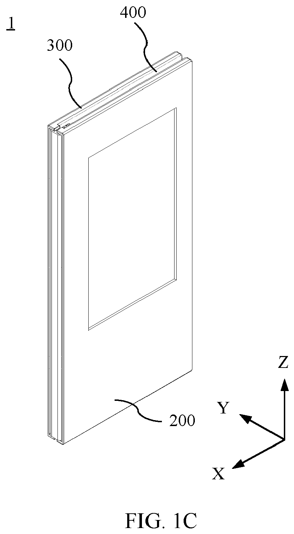

FIG. 1A is a schematic three-dimensional diagram of a foldable mobile phone in an unfolded state according to an embodiment of this application. FIG. 1B is a front view of the foldable mobile phone in the unfolded state according to this embodiment of this application. FIG. 1C is a schematic three-dimensional diagram of the foldable mobile phone in a folded state according to this embodiment of this application.

For convenience of subsequent description, before describing the specific structure of a foldable mobile phone 1, first a direction X (as a first direction), a direction Y, and a direction Z (as an axial direction) are defined with reference to FIG. 1A to FIG. 1C in this application. As shown in FIG. 1A to FIG. 1C, the direction X is a length direction of the foldable mobile phone 1. The length direction may be a length direction of a flexible screen 400 (mentioned below), or may be understood as a holding direction of a user. The direction Y is a thickness direction of the foldable mobile phone 1. The direction Z is a width direction of the foldable mobile phone. The width direction may be a width direction of the flexible screen 400, or may be understood as a direction perpendicular to a holding direction of the user in a plane where the flexible screen 400 is located. For example, the direction X, the direction Y, and the direction Z are perpendicular to each other for exemplary description.

In combination with FIG. 1A to FIG. 1C, the foldable mobile phone 1 includes a rotary mechanism 100, a first body 200, a second body 300, and the flexible screen 400. In the direction X, the first body 200 and the second body 300 are respectively disposed on two opposite sides of the rotary mechanism 100, and the first body 200 and the second body 300 are respectively connected to the rotary mechanism 100 and are capable of rotating relative to each other. For example, the first body 200 and the second body 300 are internally provided with electronic components, for example, devices such as a battery and a control circuit board.

The flexible screen 400 is fixed on the first body 200 and the second body 300. For example, the rotary mechanism 100, the first body 200, and the second body 300 are covered by the flexible screen 400. The first body 200 and the second body 300 rotate relative to each other through the rotary mechanism 100, and can drive the flexible screen 400 to move, to enable the flexible screen 400 to present a bent state or an unfolded state, so that the foldable mobile phone 1 is switched between the folded state and the unfolded state. Specifically, in some embodiments, the first body 200 and the second body 300 may rotate left and right relative to each other through the rotary mechanism 100, so that the flexible screen is unfolded or folded. Alternatively, in some other embodiments, the first body 200 and the second body 300 may be rotate up and down relative to each other through the rotary mechanism 100, to fold or unfold the flexible screen. The relative rotation direction of the first body 200 and the second body 300 is not limited in this application.

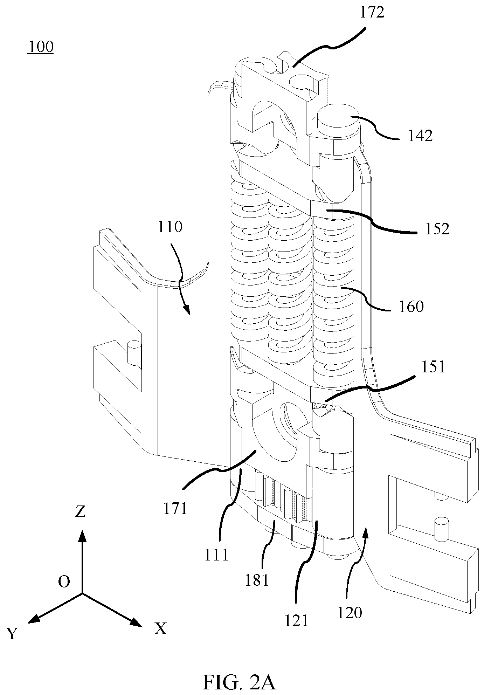

FIG. 2A to FIG. 2C are schematic diagrams of a rotary mechanism 100 when the foldable mobile phone is in the folded state in some embodiments. In combination with the foregoing accompanying drawings, in some technical solutions, the rotary mechanism 100 includes a first swing arm 110, a second swing arm 120, and a gear set 130. In the direction X, the first swing arm 110 and the second swing arm 120 are respectively disposed on two opposite sides of the gear set 130. It may alternatively be understood that, in the direction X, at least a part of the gear set 130 is disposed between the first swing arm 110 and the second swing arm 120.

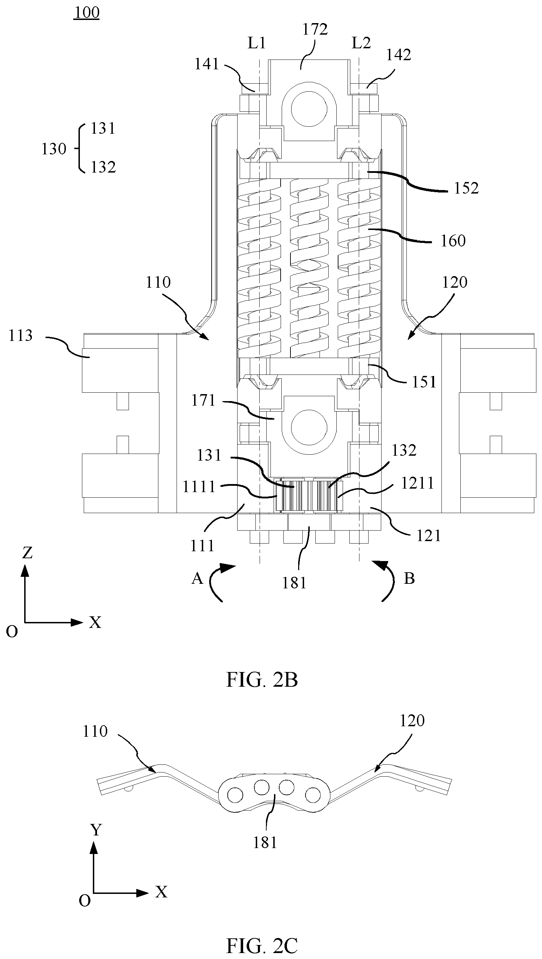

As shown in FIG. 2B, the first swing arm 110 is provided with a plurality of first gear teeth 1111, the second swing arm 120 is provided with a plurality of second gear teeth 1211, and the first gear teeth 1111 and the second gear teeth 1211 are meshed and connected through the gear set 130, so that the first swing arm 110 and the second swing arm 120 can rotate synchronously and reversely in the direction Z.

Continuously referring to FIG. 2B, specifically, the first swing arm 110 rotates around a first axis L1 in the direction A, the second swing arm 120 rotates around a second axis L2 in the direction B, and the first axis L1 and the second axis L2 extend in the direction Z. The direction A and the direction B are opposite to each other. For example, the direction A is clockwise and the direction B is counterclockwise. Although in the drawings of this application, the direction A is a clockwise direction and the direction B is a counterclockwise direction, in some other embodiments of this application, alternatively, the direction A is a counterclockwise direction and the direction B is a clockwise direction. The rotation direction may be determined according to configuration positions of the first swing arm 110 and the second swing arm 120 in the foldable mobile phone and a folding direction of the foldable mobile phone. This is not limited herein.

In the foldable mobile phone 1, the first swing arm 110 is connected to the first body 200 and can drive the first body 200 to move; and the second swing arm 120 is connected to the second body 300 and can drive the second body 300 to move. Through movements of the first swing arm 110 and the second swing arm 120, relative rotation of the first body 200 and the second body 300 can be implemented, so that the first body 200 and the second body 300 drive the flexible screen 400 to move, and the flexible screen 400 can be dynamically switched between the bent state and the unfolded state, and further the foldable mobile phone 1 can be dynamically switched between the folded state and the unfolded state, to implement a folding function of the foldable mobile phone 1.

For example, when the foldable mobile phone 1 is in the folded state, the flexible screen 400 may be bent. As shown in FIG. 1C, the bent flexible screen 400 is similar to a "U" shape. When the foldable mobile phone 1 is in the unfolded state, the flexible screen 400 may be flat. As shown in FIG. 2A and FIG. 2B, in this case, the first swing arm 110 and the second swing arm 120 of the rotary mechanism 100 are similarly in a " 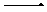 " shape, so that the flexible screen (not shown) is in a flat state.

At present, the rotary mechanism mainly includes several forms of structures such as worm gear, rack and pinion, and spiral groove. However, the structures have the problems of having difficulties in manufacturing or having a large size, which is not conducive to the production of foldable terminals and the lightness and thinness of products. For example, the worm gear structure is complicated to process (requiring a 5-axis machine for processing), the cost is high, and an intermediate turbine needs to be in a middle position in the direction Y, which has a high requirement on the space and is not conducive to production; the rack and pinion structure occupies a Z-direction space and the reduction and thinning of the foldable terminal product cannot be implemented; the spiral groove structure includes two forms: a male head is on a swing arm side and a female head is on a synchronous slider side, and the male head is on the synchronous slider side and the female head is on the swing arm side; however, the two structures also have the problems of having a high requirement on the Z-direction space and having a high processing cost.

To solve the problems, this application provides a rotary mechanism, the rotary mechanism including a first swing arm, a second swing arm, and a gear set, both the first swing arm and the second swing arm being provided with gear teeth, and the gear teeth on the two swing arms being meshed and connected through the gear set, to enable the first swing arm and the second swing arm to rotate synchronously and reversely. In addition, the gear teeth structure is integrated on the swing arms, so that the structure of the rotary mechanism is simplified, and further the rotary mechanism can be fully placed in the narrow space in the casing, which is conductive to implementing reduction and thinning of the size of a foldable machine, and is conducive to the compactness of a foldable terminal. In addition, the rotary mechanism has a simple and compact structure, has a low cost, is easy to manufacture, and has a large application range.

The rotary mechanism in the embodiments of this application will be described in detail below with reference to the accompanying drawings and specific embodiments. It should be noted that in this application, the first swing arm and the second swing arm have the same structure, and the first swing arm and the second swing arm are symmetrically arranged. In this application, for example, for the first swing arm, the specific structure of the first swing arm is described, and the structure of the second swing arm is not repeated.

### Embodiment 1

FIG. 2A, FIG. 2B, and FIG. 2C respectively are a three-dimensional diagram, a top view, and a side view of the rotary mechanism 100 in Embodiment 1 of this application. As shown in FIG. 2A to FIG. 2C, the rotary mechanism 100 includes a first swing arm 110, a second swing arm 120, and a gear set 130.

The first swing arm 110 is capable of rotating around a first axis (shown by a dotted line L₁ in FIG. 2B), and the second swing arm 120 is capable of rotating around a second axis (shown by a dotted line L₂ in FIG. 2B). The first axis and the second axis are parallel, and a rotation direction (shown by the direction A in FIG. 2A) of the first swing arm 110 is opposite to a rotation direction (shown by the direction B in FIG. 2B) of the second swing arm 120.

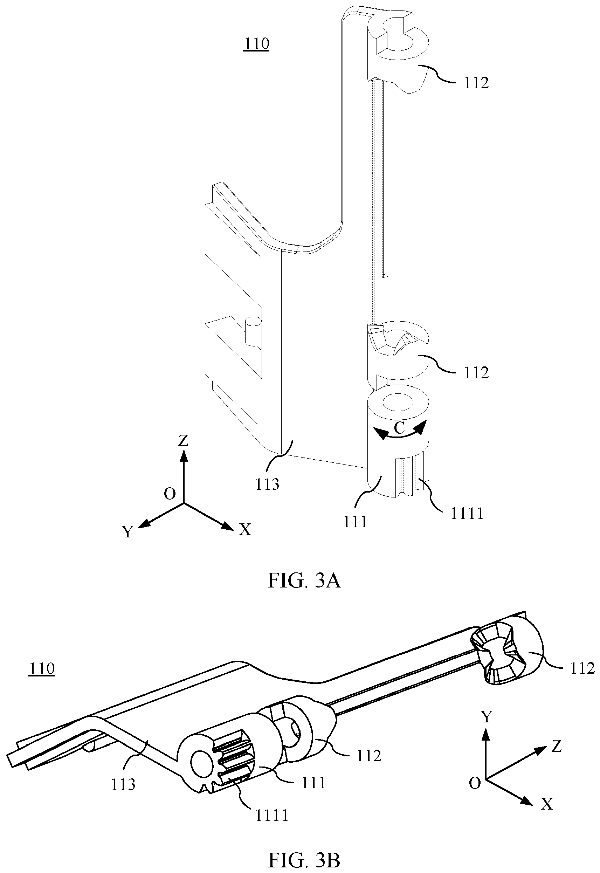

FIG. 3A and FIG. 3B are three-dimensional diagrams of the first swing arm 110 in Embodiment 1 of this application. In combination with FIG. 2B, FIG. 3A, and FIG. 3B, the first swing arm 110 includes a first rotary seat 111, a first swing arm body 113, and two first cams 112 spaced apart from each other in the direction Z. Specifically, the first rotary seat 111 and the two first cams 112 are all connected to the first swing arm body 113 and are disposed on a side, of the first swing arm body 113, facing the gear set 130. The first rotary seat 111 is provided with a plurality of first gear teeth 1111 in a circumferential direction (that is, shown by a direction C in FIG. 3A), and the first gear teeth 1111 are also disposed facing the gear set 130.

The structure of the rotary mechanism 100 is simplified by respectively disposing the plurality of first gear teeth 1111 and the plurality of second gear teeth 1211 on the first swing arm 110 and the second swing arm 120 and utilizing the gear set 130 to mesh and connect the gear teeth on the two swing arms, so that the rotary mechanism 100 can be fully placed in a narrow space in a casing, which is conductive to implementing reduction and thinning of the size of a foldable machine, and is conducive to the compactness of a foldable terminal.

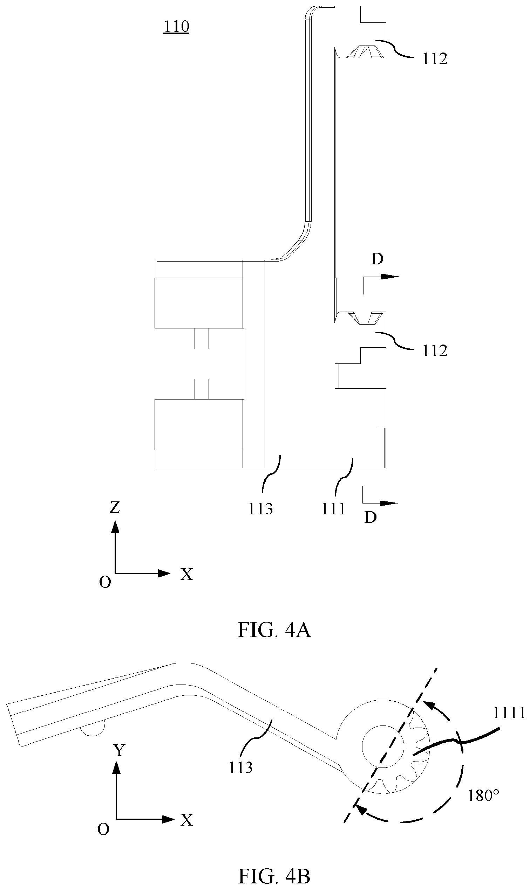

FIG. 4A and FIG. 4B are respectively a top view and a side view of the first swing arm 110 in this embodiment. In combination with FIG. 3A, FIG. 3B, FIG. 4A, and FIG. 4B, it can be seen that the first rotary seat 111 is a cylinder extending in the direction Z, one part of the first rotary seat 111 in the direction C is provided with the first gear teeth 1111, and the other part is not provided with gear teeth, so that the processing of the swing arms can be facilitated. Specifically, as shown in FIG. 4B, on a 360° circumferential surface in the circumferential direction of the first rotary seat 111, the first gear teeth 1111 may be disposed on a 180° semi-circumferential surface, of the second rotary seat 121, facing the second swing arm 120, and no gear teeth are disposed on the other semi-circumferential surface. Similarly, the second gear teeth 1211 on the second swing arm 120 may also be disposed in this manner, that is, on a 360° circumferential surface of the second rotary seat 121 in the circumferential direction, the second gear teeth 1211 may be disposed on a 180° semi-circumferential surface, of the second rotary seat 121, facing the first rotary seat 111 of the first swing arm 110, and no second gear teeth 1211 are disposed on the other semi-circumferential surface. The configuration of the semi-circumferential gear teeth can ensure that the first gear teeth 1111 and the second gear teeth 1211 are fully meshed through the gear set 130, and can also facilitate the processing of the gear teeth structures on the first swing arm 110 and the second swing arm 120.

Continuously referring to FIG. 2B, the rotary mechanism 100 further includes a first rotary shaft 141 and a second rotary shaft 142. The first rotary shaft 141 and the second rotary shaft 142 both extend in the direction Z and are spaced apart from each other in a direction X. Specifically, the first axis is an axis of the first rotary shaft 141, and the second axis is an axis of the second rotary shaft 142. The first rotary shaft 141 extends after separately passing through the two first cams 112 and the first rotary seat 111 on the first swing arm 110., so that the first swing arm 110 are capable of rotating in the direction A around the first rotary shaft 141; and the second rotary shaft 142 extends after separately passing through two second cams(the structure of the second cams on the second swing arm 120 are the same as the structure of the first cams 112 on the first swing arm 110) and the second rotary seat 121 on the second swing arm 120, so that the second swing arms 120 are capable of rotating in the direction B around the second rotary shaft 142.

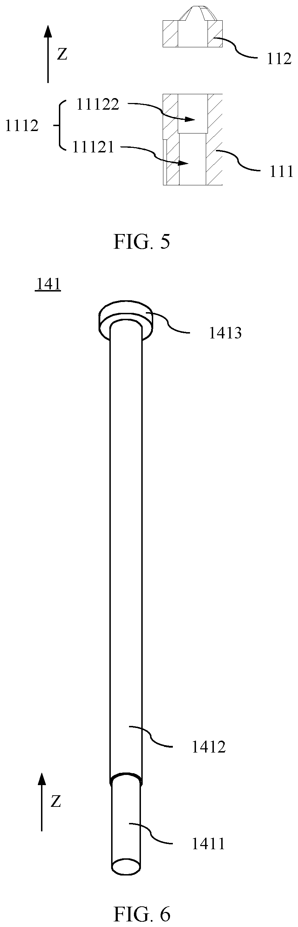

FIG. 5 is a cross-sectional view of the first rotary seat 111 and the first cams 112. FIG. 6 is a three-dimensional diagram of the first rotary shaft 141. In combination with FIG. 5 and FIG. 6, a first shaft hole 1112 for the first rotary shaft 141 to pass through is provided inside the first rotary seat 111, the first shaft hole 1112 is step-shaped in the direction Z, and correspondingly, a corresponding part of the first rotary shaft 141 is also stepped shaft-shaped in the direction Z.

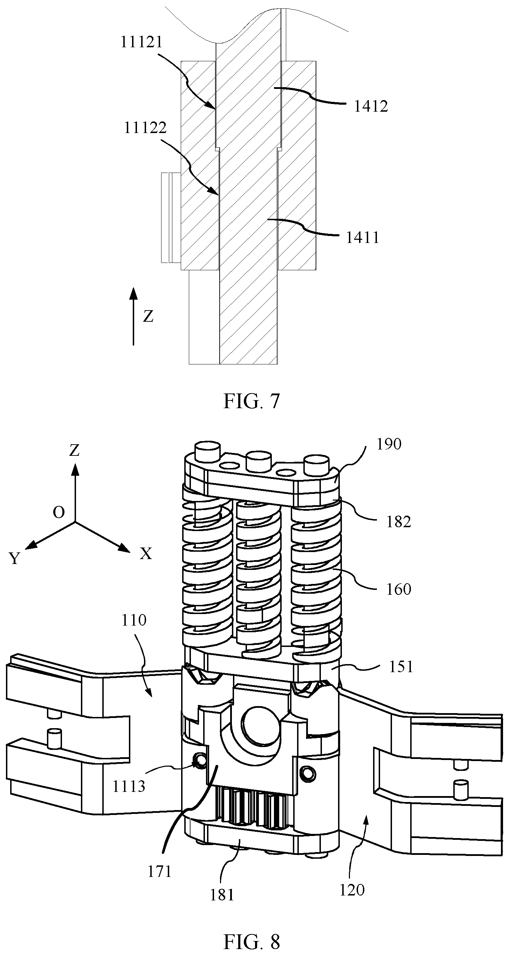

That is, in the direction Z, the first shaft hole 1112 includes a first part 11121 and a second part 11122. For example, the first part 11121 of the first shaft hole 1112 is close to an end middle frame of a first body 200 in a width direction. The first gear teeth 1111 surround an outer circumference of the first part 11121 of the first shaft hole 1112, and an aperture of the first part 11121 of the first shaft hole 1112 is smaller than an aperture of the second part 11122 of the first shaft hole 1112. Similarly, in the direction Z, the first rotary shaft 141 also includes a first part 1411 and a second part 1412, the first part 1411 of the first rotary shaft 141 is close to an end portion of a middle frame of the first body 200 in the width direction, and a diameter of the first part 1411 of the first rotary shaft 141 is smaller than a diameter of the second part 1412 of the first rotary shaft 141. As shown in FIG. 7, the first part 11121 of the first shaft hole 1112 is sleeved on the first part 1411 of the first rotary shaft 141, and the second part 11122 of the first shaft hole 1112 is sleeved on the second part 1412 of the first rotary shaft 141.

Specifically, when the size of the foldable machine is made thin, the size of the first rotary seat 111 is reduced correspondingly, and the gear teeth on the first rotary seat 111 are also directly reduced correspondingly. After a stepped hole and a stepped shaft are added, the thickness of a part of the first gear teeth 1111 is increased correspondingly, and the diameter of the first rotary shaft 141 is reduced correspondingly. In this way, the strength of the parts can be balanced and the reliability of the foldable machine is ensured. In addition, further challenge can be implemented in aspect of the size of the foldable machine, so that the foldable terminal can be made lighter and thinner.

Specifically, the structure of the second rotary shaft 142 is the same as that of the first rotary shaft 141, and the connection manner of the second rotary shaft 142 and the second swing arm 120 is also the same as that of the first rotary shaft 141 and the first swing arm 110. Details are not described herein again.

Specifically, continuously referring to FIG. 2A and FIG. 2B, the first gear teeth 1111 on the first swing arm 110 are opposite to the second gear teeth 1211 on the second swing arm 120, so that the first gear teeth 1111 and the second gear teeth 1211 are meshed and connected through the gear set 130. The gear set 130 includes a first gear 131 and a second gear 132. In the direction X, the first gear 131 and the second gear 132 are disposed between the first gear teeth 1111 and the second gear teeth 1211, and the first gear teeth 1111, the first gear 131, the second gear 132, and the second gear teeth 1211 are sequentially meshed with each other in a transmission connection.

Continuously referring to FIG. 2A and FIG. 2B, the rotary mechanism 100 further includes a first cam bracket 151 and a second cam bracket 152 spaced apart in the direction Z. The first cam bracket 151 and the second cam bracket 152 both extend in the direction X. Two ends of the first cam bracket 151 in the direction X are respectively in concave-convex fit with one of the first cams 112 on the first swing arm 110 and one of the second cams on the second swing arm 120, and two ends of the second cam bracket 152 in the direction X are respectively in concave-convex fit with another first cam 112 on the first swing arm 110 and another second cam on the second swing arm 120. Specifically, as shown in FIG. 2B, a side, of the first cam 112 on the first swing arm 110, facing the first cam bracket 151 is provided with at least one groove, a protrusion matched with the groove is provided at a corresponding position of the first cam bracket 151, and the first cam 112 and the first cam bracket 151 are connected in a concave-convex fit manner through the fitting between the protrusion and the groove. The structure of the second cam bracket 152 is similar to the structure of the first cam bracket 151. Details are not described herein again.

As shown in FIG. 2B, springs 160 are further provided between the first cam bracket 151 and the second cam bracket 152 in the direction Z. Specifically, a plurality of springs 160 are provided, and may be respectively sleeved on the first rotary shaft 141 and the second rotary shaft 142. That is, the corresponding first rotary shaft 141 and second rotary shaft 142 respectively pass through the springs 160, and the springs 160 can slide in the direction Z; one ends of the springs 160 are in contact with the first cam bracket 151, and the other ends thereof are in contact with the second cam bracket 152. In this way, during synchronous rotation of the first swing arm 110 and the second swing arm 120, the springs 160 can provide a rotation damping force of the swing arms through the cams.

The springs 160 are limited by disposing two first cams 112/second cams on the first swing arm 110/the second swing arm 120 at an interval in the direction Z, a circlip bracket 190 does not need to be additionally added to limit the two ends of the springs 160, so that the axial space is further saved.

Further, continuously referring to FIG. 2B, the rotary mechanism 100 further includes a first support frame 181, a first fixing bracket 171, and a second fixing bracket 172. Specifically, the first fixing bracket 171 and the first support frame 181 are arranged at two opposite sides of the gear set 130 in the direction Z, the first support frame 181 is arranged on one side of an end portion of the rotary mechanism 100 close to the middle frame, and the second fixing bracket 172 is arranged on the other side of the end of the rotary mechanism 100 away from the middle frame. In the direction Z, the first rotary shaft 141 extends out after sequentially passing through the first support frame 181, the first rotary seat 111, the first fixing bracket 171, the first cam 112, the first cam bracket 151, the spring 160, the second cam bracket 152, the another first cam 112, and the second fixing bracket 172; similarly, in the direction Z, the second rotary shaft 142 extends out after sequentially passing through the first support frame 181, the second rotary seat 121, the first fixing bracket 171, the second cam, the first cam bracket 151, the spring 160, the second cam bracket 152, the another second cam, and the second fixing bracket 172.

Further, referring to FIG. 6, an end portion of the first rotary shaft 141 is further provided with a stuck cap 1413, so that after the first rotary shaft 141 passes through the second fixing bracket 172, the stuck cap 1413 is engaged with an end surface behind the second fixing bracket 172, so as to limit the first rotary shaft 141 and prevent the first rotary shaft 141 from moving towards the gear set 130 in the direction Z.

The first support frame 181 extends in the direction X, and is provided with four through holes arranged at an interval in the direction X. First end portions of the first rotary shaft 141, the first gear 131, the second gear 132, and the first end of the second rotary shaft 142 on a same side all pass through the corresponding through holes in the first support frame 181. A side, of the first fixing bracket 171, facing the first gear 131 and the second gear 132 is provided with a first mounting hole, and second ends of the first gear 131 and the second gear 132 pass through the first mounting hole of the first fixing bracket 171.

Further, two sides of the first fixing bracket 171 and the second fixing bracket 172 in the direction X are respectively provided with second mounting holes for fixing the first rotary shaft 141 and the second rotary shaft 142, and the first rotary shaft 141 and the second rotary shaft 142 are fixedly connected to the rotary mechanism 100 through the second mounting hole on the first fixing bracket 171 and the second mounting hole on the second fixing bracket 172.

### Embodiment 2

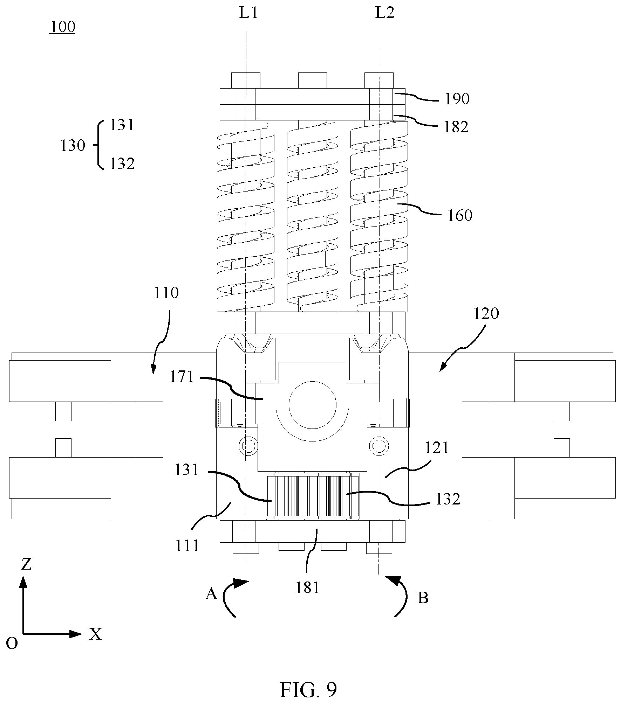

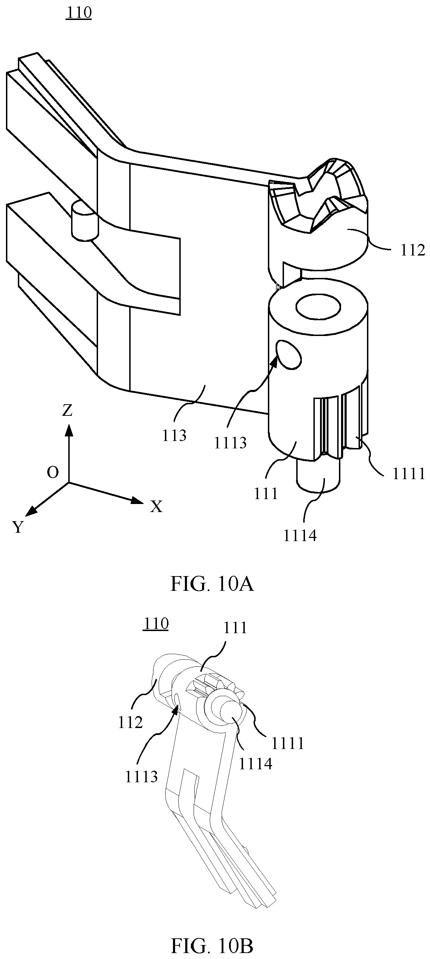

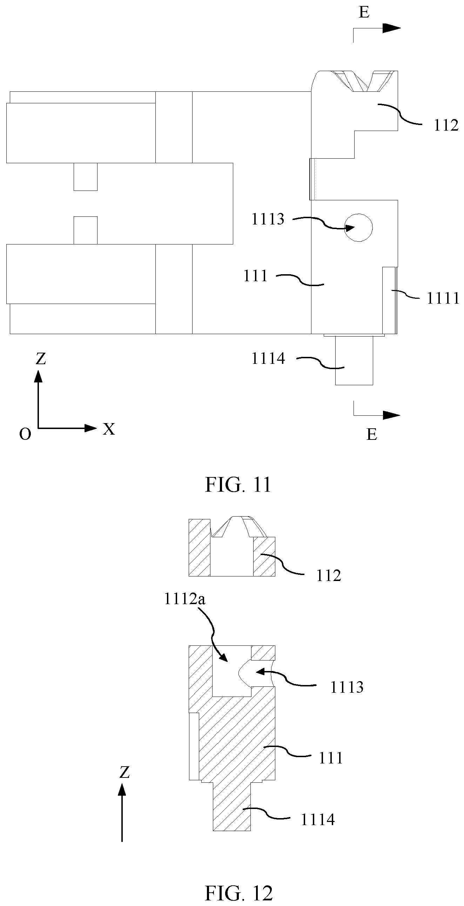

FIG. 8 and FIG. 9 are respectively a three-dimensional diagram and a top view of a rotary mechanism 100 in Embodiment 2. FIG. 10A to FIG. 12 are schematic structural diagrams of a first swing arm 110 in Embodiment 2. FIG. 10A and FIG. 10B are three-dimensional diagrams of the first swing arm 110 at two angles, FIG. 11 is a top view of the first swing arm 110, and FIG. 12 is a cross-sectional view of a first rotary seat 111 and first cams 112 on the first swing arm 110.

Referring to FIG. 2A and FIG. 2B of Embodiment 1 and FIG. 8 and FIG. 9 of Embodiment 2, it can be seen that the rotary mechanisms 100 of Embodiment 2 and Embodiment 1 both include a first swing arm 110, a second swing arm 120, and a gear set 130, the first swing arm 110 and the second swing arm 120 are similarly, respectively provided with a first gear teeth 1111 and a second gear teeth 1211, and in addition, the rotation modes of the first swing arm 110 and the second swing arm 120, the configuration positions and configuration modes of the first gear teeth 1111 and the second gear teeth 1211, the specific structure of the gear set 130, and the connection mode of the gear set 130 and the first gear teeth 1111 and the second gear teeth 1211 are also the same. Details are not described herein again, and only differences between Embodiment 1 and Embodiment 2 are described below.

Referring to FIG. 4A and FIG. 5 of Embodiment 1 and FIG. 10A to FIG. 12 of Embodiment 2, it can be seen that the structure of the first swing arm 110 in Embodiment 2 and that the first swing arm 110 Embodiment 1 are not the same. Specifically:
the first shaft hole 1112 provided inside the first rotary seat 111 in the first swing arm 110 of Embodiment 1 is in the form of a stepped hole, and the first shaft hole 1112 runs through the rotary seat 111 in the direction Z. Correspondingly, in Embodiment 1, a stepped shaft is also provided at a corresponding position of the first rotary shaft 141, and the first rotary shaft 141 passes through and extends out of the first rotary seat 111; in addition the first rotary shaft 141 and the first rotary seat 111 are rotatably connected, and an end portion of the first rotary seat 111 is not provided with an additional rotating shaft.

However, in Embodiment 2, referring to FIG. 11 and FIG. 12, a first shaft hole 1112a provided inside the first rotary seat 111 in the first swing arm 110 is in a form of a straight hole, instead of a stepped hole, and the first shaft hole 1112a does not run through the first rotary seat 111, but is provided at an end of the first rotary seat 111 away from the gear set 130. Therefore, the first rotary shaft 141 in Embodiment 2 is not provided with a stepped shaft and does not pass through the first rotary seat 111, but is mounted inside the first rotary seat 111, and the first rotary shaft 141 is fixedly connected to the first swing arm 110.

Specifically, as shown in FIG. 12, a pin hole 1113 is provided in a side wall of the first rotary seat 111, and the pin hole 1113 runs through the first shaft hole 1112a. After the first rotary shaft 141 is inserted into the first shaft hole 1112a, the first rotary shaft 141 may be fixed to the first rotary seat 111 through a pin passing through the pin hole 1113, so that the first rotary shaft 141 is fixedly connected to the first swing arm 110. Specifically, the first rotary shaft 141 and the first swing arm 110 may alternatively be fixedly connected by spot welding or the like, or the first swing arm 110 and the first rotary shaft 141 may be integrated. This is not limited herein.

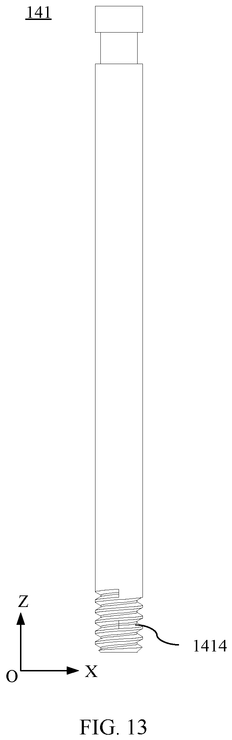

FIG. 13 is a three-dimensional diagram of the first rotary shaft 141 in Embodiment 2. In combination with FIG. 11, FIG. 12, and FIG. 13, it can be seen that the first shaft hole 1112a in the first rotary seat 111 may be a threaded hole, and a corresponding end portion of the first rotary shaft 141 is provided with a threaded structure 1414. By using the threaded design, on one hand, the first rotary shaft 141 can be screwed into the first shaft hole 1112a in the first rotary seat 111, and on the other hand, the fixed connection between the first rotary shaft 141 and the first rotary seat 111 is further enhanced.

Further, continuously referring to FIG. 10A and FIG. 12, to facilitate rotation of the first swing arm 110 around the first axis, one end of the first gear teeth 1111 of the first rotary seat 111 is further provided with a first rotating shaft 1114, and the first rotating shaft 1114 extends in the direction Z and is coaxial with the first rotary shaft 141. Specifically, the first rotating shaft 1114 is arranged at an end of the first rotary seat 111 close to the middle frame in the direction Z, and the first shaft hole 1112a is provided inside the other end of the first rotary seat 111 in the direction Z, that is, no hole structures are provided inside the part where the first gear teeth 1111 are located. In this way, the strength of a part of the first gear teeth 1111 can be further improved.

That is, in Embodiment 2, the first rotary shaft 141 passes through the first cams 112 on the first swing arm 110, then extends into the first shaft hole 1112a in the first rotary seat 111, and is fixedly connected to the first rotary seat 111; the first rotating shaft at one end of the first rotary seat 111 is rotatably connected to the first support frame 181 disposed on the side, so that the first swing arm 110 is capable of rotating in the direction around the first rotary shaft 141; similarly, the second rotary shaft 142 passes through the second cams on the second swing arm 120 (specifically, in this embodiment, the structure of the second cams on the second swing arm 120 are the same as the structure of the first cams 112 on the first swing arm 110), then extends into the second shaft hole in the second rotary seat 121, and is connected to the second rotary seat 121, and the second rotating shaft at one end of the second rotary seat 121 is rotatably connected to the first support frame 181 disposed on the side, so that the second swing arm 120 is capable of rotating around the second rotary shaft 142 in the direction B.

In Embodiment 2, the structure of the stepped hole in the rotary seat and the corresponding part of the rotary shaft being configured as a stepped shafts is canceled, and instead, a rotary shaft is added at end portions of the gear teeth, and the rotary shaft is utilized to support the rotation of the rotary seat; in addition, to ensure the reliability of the overall structure of the rotary shaft and the swing arm, the rotation and the swing arm are configured as an integrated connection structure in this embodiment, so that the strength of the parts is ensured, and further the reliability of the foldable machine is ensured. In addition, further challenge can be implemented in aspect of the size of the foldable machine, so that the foldable terminal can be made lighter and thinner.

Further, numbers of cams on the swing arms in Embodiment 2 are also different from those in Embodiment 1. For example, for the first swing arm 110, referring to FIG. 3A and FIG. 10A, different from the two first cams 112 arranged on the first swing arm 110 at an interval in the direction Z in Embodiment 1, only one first cam 112 is arranged on the first swing arm 110 in Embodiment 2. Specifically, the first cam 112 is located on a side of the first rotary seat 111 away from the gear set 130, and a through hole for the first rotary shaft 141 to pass through is further provided inside the first cam 112.

Correspondingly, for one cam is arranged on the swing arm, and the swing arm is fixedly connected to the rotary shaft, the composition of the rotary mechanism 100 in Embodiment 2 is also different from the composition of the rotary mechanism 100 in Embodiment 1. Continuously referring to FIG. 2B and FIG. 9, compared with the rotary mechanism 100 of Embodiment 1, in the rotary mechanism 100 of Embodiment 2, a second cam bracket 152 arranged on a side away from the gear set 130 is omitted, and instead, a third support frame 182 and a circlip bracket 190 are added to limit the end portions of the springs 160 on the side, so that during synchronous rotation of the first swing arm 110 and the second swing arm 120, the springs 160 can provide a rotation damping force of the swing arms through the cam and the circlip bracket 190. In addition, the first rotary shaft 141/the second rotary shaft 142 is fixedly connected to the first swing arm 110/the second swing arm 120, and therefore, in Embodiment 2, the first rotary shaft 141 and the second rotary shaft 142 are rotatably connected to the first fixing bracket 171.

That is, by adding the circlip bracket 190 to reduce the numbers of cams on a swing arm, the structure of the swing arm can be simplified, which is conductive to the production of swing arms.

### Embodiment 3

It should be noted that the structure of the rotary mechanism 100 in Embodiment 3 is partially the same as that of the rotary mechanism 100 in Embodiment 2. For ease of description, the part of identical structures of Embodiment 3 and Embodiment 2 is not described in detail below, and only the part of a structure of Embodiment 3 different from that of Embodiment 2 is described.

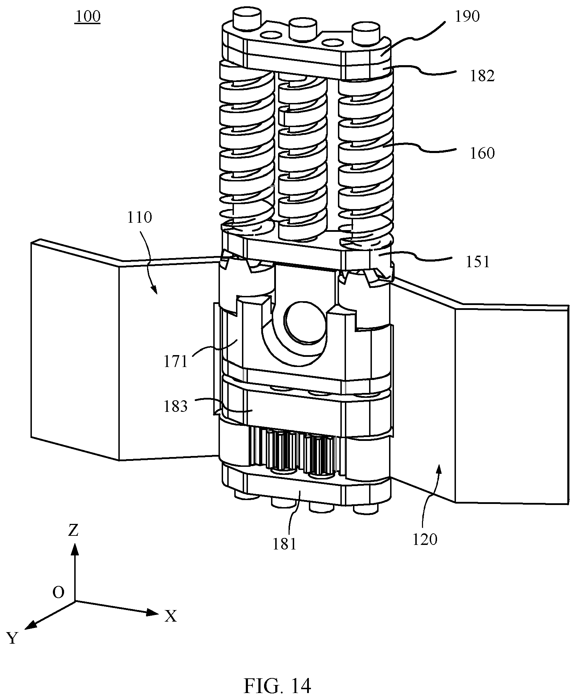

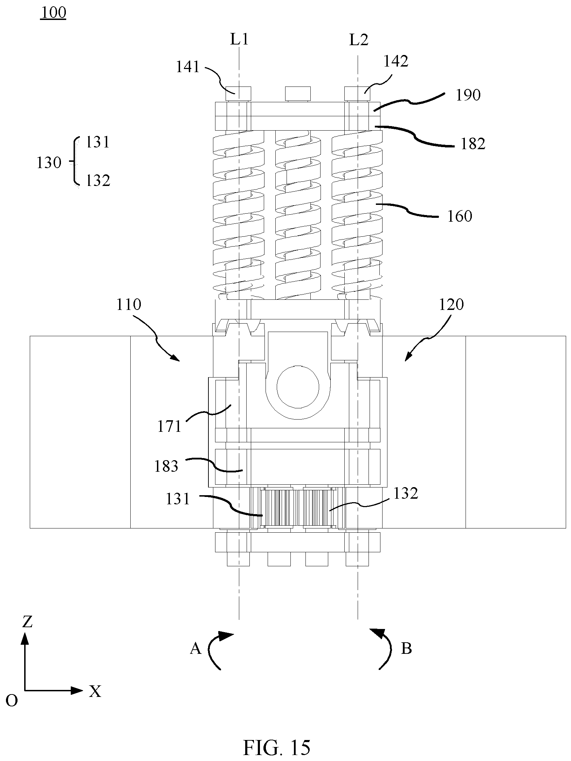

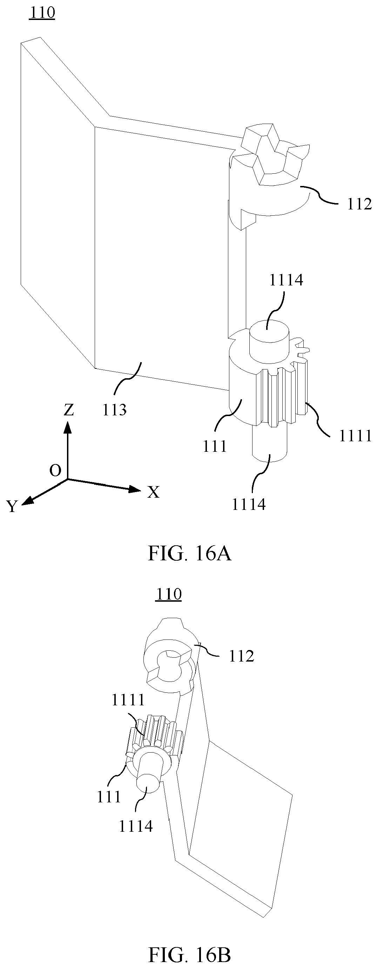

FIG. 14 and FIG. 15 are respectively a three-dimensional diagram and a top view of the rotary mechanism 100 in Embodiment 3. FIG. 16A and FIG. 16B are schematic structural diagrams of the first swing arm 110 in Embodiment 3. As shown in FIG. 14 to FIG. 16B, the different structure between Embodiment 3 and Embodiment 2 lies in a difference in the structure of the first rotary seat 111 on the first swing arm 110. In Embodiment 3, two ends of the first gear teeth 1111 on the first rotary seat 111 are each provided with a first rotating shaft 1114, and corresponding to the structure, in Embodiment 3, the rotary mechanism 100 further includes a second support frame 183 added between the first fixing bracket 171 and the gear set 130. Specifically as detailed below:
as shown in FIG. 16A and FIG. 16B, two ends of the first gear teeth 1111 on the first rotary seat 111 in the direction Z are each provided with a first rotating shaft 1114. Each of the first rotating shafts 1114 extends in the direction Z and is coaxial with the first rotary shaft 141.

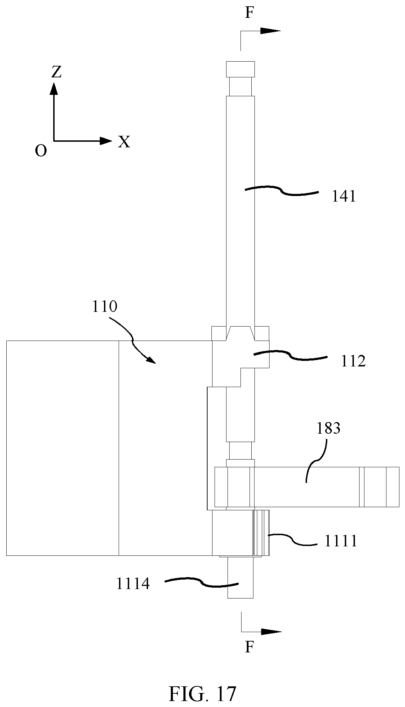

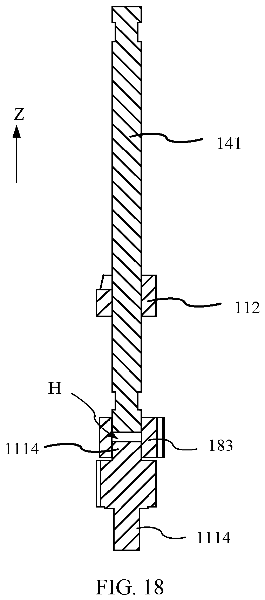

Specifically, the second support frame 183 extends in the direction X. The first gear teeth 1111 include a first end and a second end. The first end is defined as one end facing the first rotary shaft 141, and the second end is defined as one end away from the first rotary shaft 141. As shown in FIG. 17 and FIG. 18, the first rotating shaft 1114 disposed on the second end of the first gear teeth 1111 and an end portion of the first rotary shaft 141 are both sleeved in one end of the second support frame 183 in the direction X, and are rotatably connected to the second support frame 183. Further, there is a particular gap H between the first rotating shaft 1114 and the first rotary shaft 141 in the direction Z, so as to avoid unnecessary wear caused by contact between end portions of the first rotating shaft 1114 and the first rotary shaft 141.

Similarly, second gear teeth 1211 on the second swing arm 120 also includes a first end and a second end. The first end is defined as one end facing the second rotary shaft 142, and the second end is defined as one end away from the second rotary shaft 142. A second rotating shaft disposed on the second end of the second gear teeth 1211 and an end portion of the second rotary shaft 142 are both sleeved in the other end of the second support frame 183 in the direction X, and are rotatably connected to the second support frame 183. Further, there is a particular gap H between the second rotating shaft and the second rotary shaft 142 in the direction Z, so as to avoid unnecessary wear caused by contact between end portions of the second rotating shaft and the second rotary shaft 142.

Specifically, when the size of the foldable machine is made thin, the size of the rotary seat on the swing arm is reduced correspondingly, and the gear teeth on the rotary seat are also directly reduced correspondingly. In the third embodiment, by adding the rotating shafts at two ends of the gear teeth of the rotary seat of the swing arm, the first gear teeth 1111/the second gear teeth 1211 are capable of rotating around the rotating shafts thereof, so that there is no need to configure the first rotary shaft 141 or the second rotary shaft 142 to pass through the corresponding first gear teeth 1111 or second gear teeth 1211, the thickness of the part of the gear teeth is ensured, the strength of the parts is improved, and the reliability of the foldable machine is ensured. In addition, further challenge can be implemented in aspect of the size of the foldable machine, so that the foldable terminal can be made lighter and thinner.

### Embodiment 4

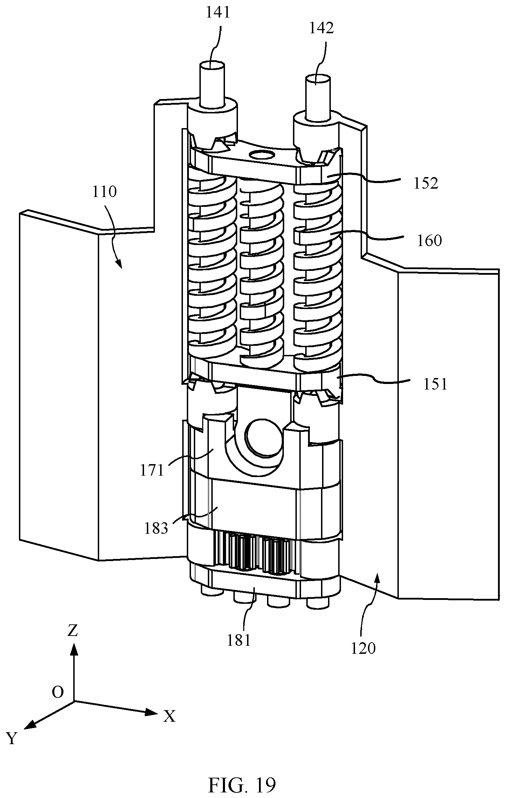

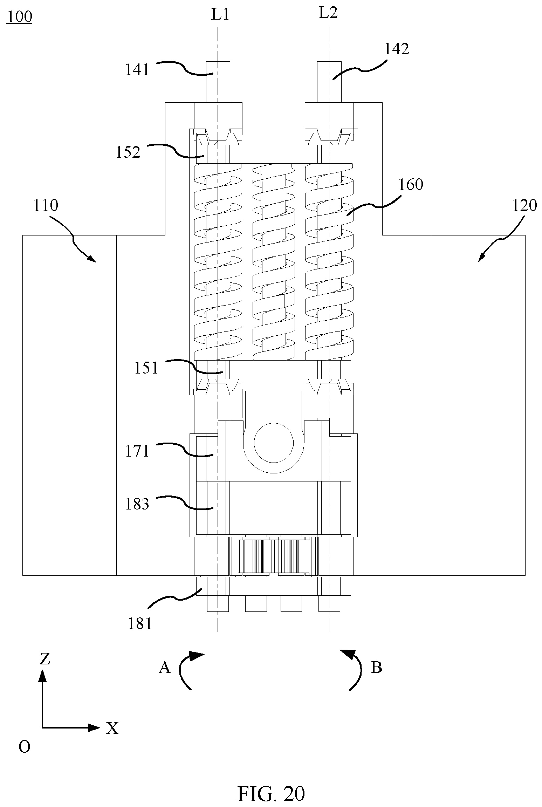

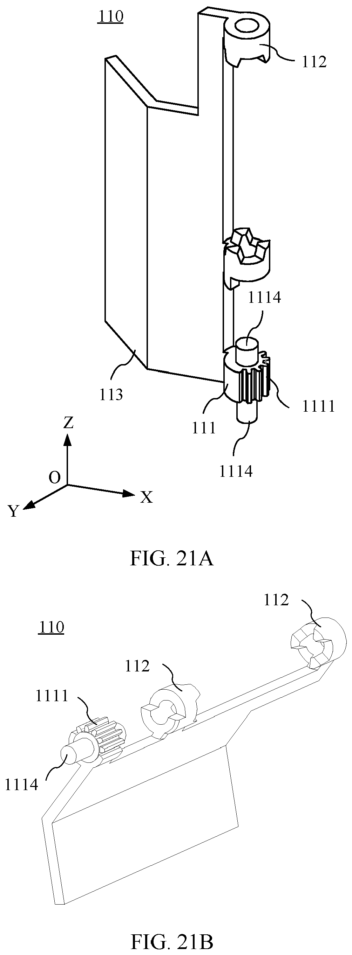

FIG. 19 and FIG. 20 are respectively a three-dimensional diagram and a top view of the rotary mechanism 100 in Embodiment 4. FIG. 21A and FIG. 21B are schematic diagrams of the first swing arm 110 in Embodiment 4.

As can be seen from FIG. 21A and FIG. 21B, the structure of the swing arm in Embodiment 4 is different from that in Embodiment 3. Specifically, the structure of the rotary seat in the swing arm in Embodiment 4 is the same as structure of the rotary seat in the swing arm in Embodiment 3, but the configuration of the cams on the swing arm is different from the configuration of the cams in Embodiment 3. Similarly, for example, for the first swing arm 110, as shown in FIG. 21, in Embodiment 4, two first cams 112 are arranged on the first swing arm 110 at an interval in the direction Z, and the two first cams 112 are both located on a side of the first rotary seat 111 away from the gear set 130.

Correspondingly, for the two cams arranged on the swing arm, the composition of the rotary mechanism 100 in Embodiment 4 is also different from the composition of the rotary mechanism 100 in Embodiment 3. Referring to FIG. 15 and FIG. 20, by comparing the rotary mechanism 100 of Embodiment 3 and the rotary mechanism 100 of Embodiment 4, structures of the parts (specifically including the first cam bracket 151, the first fixing bracket 171, the second support frame 183, the rotary seat on each swing arm, the gear set 130, and the first support frame 181) located below the springs 160 are the same, and the parts located above the springs 160 are different.

In Embodiment 4, two first cams 112/second cams are arranged on the first swing arm 110/the second swing arm 120 at an interval in the direction Z to limit the springs 160. Therefore, there is no need to further arranging the third support frame 182 and the circlip bracket 190 in Embodiment 3 to limit the end portions of the springs 160. Instead, in Embodiment 4, the second cam bracket 152 is arranged at the position of the cam, so that the second cam bracket 152 is in concave-convex fit with the cams on the first swing arm 110 and the second swing arm 120 to limit the end portions of the springs 160. By the solution, the space occupied by the rotary mechanism 100 in the axial direction can be further reduced. Specifically, the structure of the second cam bracket 152 is the same as the structure of the second cam bracket 152 in Embodiment 1. Details are not described herein again.

In view of the above, for the rotary mechanism of the embodiments of this application, the structure of the rotary mechanism is simplified by integrating and providing a gear teeth structure on the swing arms and utilizing the gear set to mesh and connect the gear teeth on the two swing arms, so that the rotary mechanism can be fully placed in a narrow space in a casing, which is conducive to implementing reduction and thinning of the size of a foldable machine, and is conducive to the compactness of a foldable terminal. In addition, the rotary mechanism has a simple and compact structure, a low cost, and a large application range.

## Claims

1. A rotary mechanism (100), comprising:
a first swing arm (110), provided with a first rotary seat (111), the first swing arm being capable of rotating around a first axis (L1), wherein the first swing arm is provided with a first cam (112), the first cam and the first rotary seat are spaced apart from each other in an axial direction;
a second swing arm (120), provided with a second rotary seat (121), the second swing arm being capable of rotating around a second axis (L2), and the second axis being parallel to the first axis, wherein the second swing arm is provided with a second cam, the second cam and the second rotary seat are spaced apart from each other in the axial direction, the first cam and the second cam are arranged correspondingly; and
a cam bracket (151), one end of the cam bracket is in concave-convex fit with the first cam, the other end of the cam bracket is in concave-convex fit with the second cam; wherein
the first rotary seat is provided with a plurality of first gear teeth (1111) distributed in a circumferential direction, the second rotary seat is provided with a plurality of second gear teeth (1211) distributed in a circumferential direction, and the plurality of first gear teeth and the plurality of second gear teeth are meshed and connected through a gear set (130), to enable the first swing arm and the second swing arm to rotate synchronously and reversely,
**characterized in that**
the rotary mechanism further comprises a first fixing bracket (171) and a first support frame (181), the first support frame and the first fixing bracket are spaced apart on two sides of the gear set in the axial direction, a first end of the gear set is rotatably connected to the first support frame and a second end of the gear set is rotatably connected to the first fixing bracket.

2. The rotary mechanism (100) according to claim 1, wherein a part of the first rotary seat (111) extending in the circumferential direction is provided with the plurality of first gear teeth (1111), and a part of the second rotary seat (121) extending in the circumferential direction is provided with the plurality of second gear teeth (1211).

3. The rotary mechanism according to claim 1, wherein the gear set (130) comprises a first gear (131) and a second gear (132), the first gear is separately meshed with the first gear teeth (1111) and the second gear, and the second gear is separately meshed with the first gear and the second gear teeth (1211).

4. The rotary mechanism (100) according to any one of claims 1 to 3, wherein the rotary mechanism further comprises a first rotary shaft (141), and the first axis is an axis of the first rotary shaft;
the first rotary seat (111) comprises a first shaft hole (1112a), the first shaft hole comprises a first part (11121) and a second part (11122) in an axial direction, the first part of the first shaft hole is arranged corresponding to the first gear teeth (1111), and an aperture of the first part of the first shaft hole is smaller than an aperture of the second part of the first shaft hole; and
the first rotary shaft comprises a first part (1411) and a second part (1412), a diameter of the first part of the first rotary shaft is smaller than a diameter of the second part of the first rotary shaft, the first part of the first shaft hole is sleeved on the first part of the first rotary shaft, and the second part of the first shaft hole is sleeved on the second part of the first rotary shaft.

5. The rotary mechanism (100) according to any one of claims 1 to 3, wherein the rotary mechanism further comprises a second rotary shaft (142), and the second axis is an axis of the second rotary shaft;
the second rotary seat comprises a second shaft hole, the second shaft hole comprises a first part and a second part in an axial direction, the first part of the second shaft hole is arranged corresponding to the second gear teeth, and an aperture of the first part of the second shaft hole is smaller than an aperture of the second part of the second shaft hole; and
the second rotary shaft comprises a first part and a second part, a diameter of the first part of the second rotary shaft is smaller than a diameter of the second part of the second rotary shaft, the first part of the second shaft hole is sleeved on the first part of the second rotary shaft, and the second part of the second shaft hole is sleeved on the second part of the second rotary shaft.

6. The rotary mechanism (100) according to any one of claims 1 to 3, wherein the rotary mechanism further comprises a first rotary shaft (141), and the first axis is an axis of the first rotary shaft; one end of the first rotary seat (111) is provided with a first rotating shaft integrally formed with the first rotary seat, and the other end of the first rotary seat is fixedly connected to the first rotary shaft; and/or, the rotary mechanism further comprises a second rotary shaft (142), and the second axis is an axis of the second rotary shaft; and one end of the second rotary seat is provided with a second rotating shaft integrally formed with the second rotary seat, and the other end of the second rotary seat is fixedly connected to the second rotary shaft.

7. The rotary mechanism (100) according to claim 6, wherein the first support frame (181) extends in a first direction, the first direction is perpendicular to the first axis, and two ends of the first support frame in the first direction are rotatably connected to the first rotating shaft (141) and the second rotating shaft (142), respectively.

8. The rotary mechanism (100) according to any one of claims 1 to 3, wherein two ends of the first rotary seat (111) are each provided with a first rotating shaft (1114) integrally formed with the first rotary seat, and two ends of the second rotary seat are each provided with a second rotating shaft integrally formed with the second rotary seat;
the rotary mechanism further comprises a first rotary shaft (141), a second rotary shaft (142), the first support frame (181), and a second support frame (183); the first rotary seat (111), the second rotary seat, and the gear set (130) are arranged between the first support frame and the second support frame; the first support frame and the second support frame extend in a first direction, the first direction is perpendicular to the first axis, the first axis is an axis of the first rotary shaft, and the second axis is an axis of the second rotary shaft;
two ends of the first support frame in the first direction are rotatably connected to the first rotating shaft at one end of the first rotary seat and the second rotating shaft at one end of the second rotary seat, respectively; and
two ends of the second support frame in the first direction are provided with a first through hole and a second through hole, respectively, the first rotating shaft at the other end of the first rotary seat and one end of the first rotary shaft are disposed in the first through hole, and the second rotating shaft at the other end of the second rotary seat and one end of the second rotary shaft are disposed in the second through hole.

9. The rotary mechanism (100) according to claim 1, wherein two first cams (112) are arranged on the first swing arm (110) at an interval in an axial direction, two second cams are arranged on the second swing arm (120) at an interval in the axial direction, and the first cams and the second cams are arranged correspondingly;
a first cam bracket (151) and a second cam bracket (152) are arranged at an interval in the axial direction between the two first cams, the first cam bracket and the second cam bracket both extend in a first direction, and the first direction is perpendicular to the first axis;
one end of the first cam bracket and one end of the second cam bracket are respectively in concave-convex fit with the corresponding first cams, and the other end of the first cam bracket and the other end of the second cam bracket are respectively in concave-convex fit with the corresponding second cams;
the rotary mechanism further comprises a first rotary shaft (141) and a second rotary shaft (142), the first axis is an axis of the first rotary shaft, and the second axis is an axis of the second rotary shaft;
one end of the first rotary shaft is connected to the first rotary seat (111), and the other end of the first rotary shaft passes through the first cams, one end of the first cam bracket, and one end of the second cam bracket;
one end of the second rotary shaft is connected to the second rotary seat, and the other end of the second rotary shaft passes through the second cams, the other end of the first cam bracket, and the other end of the second cam bracket; and
springs (160) are sleeved on both the first rotary shaft and the second rotary shaft, and the springs are located between the first cam bracket and the second cam bracket.

10. The rotary mechanism (100) according to claim 1, wherein the first swing arm (110) is provided with a first cam (112), the second swing arm (120) is provided with a second cam, and the first cam and the second cam are arranged correspondingly;
the rotary mechanism further comprises a first rotary shaft (141), a second rotary shaft (142), a cam bracket (152), and a third support frame (182), both the cam bracket and the third support frame extend in a first direction and are arranged at an interval in an axial direction, and the first direction is perpendicular to the axial direction;
one end of the cam bracket is in concave-convex fit with the first cam, the other end of the cam bracket is in concave-convex fit with the second cam, a side of the third support frame away from the cam bracket in the axial direction is provided with a circlip bracket (190), and the circlip bracket extends in the first direction;
one end of the first rotary shaft is connected to the first rotary seat (111), and the other end of the first rotary shaft sequentially passes through the first cam, one end of the cam bracket, one end of the third support frame, and one end of the circlip bracket; one end of the second rotary shaft is connected to the second rotary seat, and the other end of the second rotary shaft passes through the second cam, the other end of the cam bracket, the other end of the third support frame, and the other end of the circlip bracket; and springs are sleeved on both the first rotary shaft and the second rotary shaft, and the springs are located between the cam bracket and the third support frame.

11. A foldable terminal (1), comprising:
a first body (200);
a second body (300); and
the rotary mechanism (100) according to any one of claims 1 to 10, wherein the first swing arm (110) in the rotary mechanism is connected to the first body, and the second swing arm (120) in the rotary mechanism is connected to the second body.

12. The foldable terminal (1) according to claim 11, further comprising: a flexible screen (400), wherein the flexible screen covers the first body (200), the second body (300), and the rotary mechanism (100).

## Patentansprüche

1. Drehmechanismus (100), umfassend:
einen ersten Schwenkarm (110), der mit einem ersten Drehsitz (111) versehen ist, wobei der erste Schwenkarm um eine erste Achse (L1) drehbar ist, wobei der erste Schwenkarm mit einem ersten Nocken (112) versehen ist, wobei der erste Nocken und der erste Drehsitz in axialer Richtung voneinander beabstandet sind;
einen zweiten Schwenkarm (120), der mit einem zweiten Drehsitz (121) versehen ist, wobei der zweite Schwenkarm um eine zweite Achse (L2) drehbar ist und die zweite Achse parallel zur ersten Achse verläuft, wobei der zweite Schwenkarm mit einem zweiten Nocken versehen ist, wobei der zweite Nocken und der zweite Drehsitz in axialer Richtung voneinander beabstandet sind, wobei der erste Nocken und der zweite Nocken korrespondierend angeordnet sind; und
eine Nockenhalterung (151), wobei ein Ende der Nockenhalterung in konkav-konvexer Passung mit dem ersten Nocken steht, das andere Ende der Nockenhalterung in konkav-konvexer Passung mit dem zweiten Nocken steht; wobei
der erste Drehsitz mit einer Vielzahl von ersten Zahnradzähnen (1111) versehen ist, die in Umfangsrichtung verteilt sind, der zweite Drehsitz mit einer Vielzahl von zweiten Zahnradzähnen (1211) versehen ist, die in Umfangsrichtung verteilt sind, und die Vielzahl der ersten Zahnradzähne und die Vielzahl der zweiten Zahnradzähne über einen Zahnradsatz (130) kämmend verbunden sind, um eine synchrone und gegenläufige Drehung des ersten Schwenkarms und des zweiten Schwenkarms zu ermöglichen,
**dadurch gekennzeichnet, dass** der Drehmechanismus ferner eine erste Befestigungshalterung (171) und einen ersten Stützrahmen (181) umfasst, wobei der erste Stützrahmen und die erste Befestigungshalterung auf zwei Seiten des Zahnradsatzes in axialer Richtung beabstandet sind, ein erstes Ende des Zahnradsatzes drehbar mit dem ersten Stützrahmen verbunden ist und ein zweites Ende des Zahnradsatzes drehbar mit der ersten Befestigungshalterung verbunden ist.

2. Drehmechanismus (100) nach Anspruch 1, wobei ein Teil des ersten Drehsitzes (111), der sich in Umfangsrichtung erstreckt, mit der Vielzahl der ersten Zahnradzähne (1111) versehen ist und ein Teil des zweiten Drehsitzes (121), der sich in Umfangsrichtung erstreckt, mit der Vielzahl der zweiten Zahnradzähne (1211) versehen ist.

3. Drehmechanismus nach Anspruch 1, wobei der Zahnradsatz (130) ein erstes Zahnrad (131) und ein zweites Zahnrad (132) umfasst, wobei das erste Zahnrad separat mit den ersten Zahnradzähnen (1111) und dem zweiten Zahnrad kämmt und das zweite Zahnrad separat mit dem ersten Zahnrad und den zweiten Zahnradzähnen (1211) kämmt.

4. Drehmechanismus (100) nach einem der Ansprüche 1 bis 3, wobei der Drehmechanismus ferner eine erste Drehwelle (141) umfasst und die erste Achse eine Achse der ersten Drehwelle ist;
der erste Drehsitz (111) umfasst ein erstes Wellenloch (1112a), wobei das erste Wellenloch in einer axialen Richtung einen ersten Teil (11121) und einen zweiten Teil (11122) umfasst, wobei der erste Teil des ersten Wellenlochs entsprechend den ersten Getriebezähnen (1111) angeordnet ist und eine Öffnung des ersten Teils des ersten Wellenlochs kleiner ist als eine Öffnung des zweiten Teils des ersten Wellenlochs; und
die erste Drehwelle umfasst einen ersten Teil (1411) und einen zweiten Teil (1412), wobei ein Durchmesser des ersten Teils der ersten Drehwelle kleiner ist als ein Durchmesser des zweiten Teils der ersten Drehwelle, wobei der erste Teil des ersten Wellenlochs auf den ersten Teil der ersten Drehwelle aufgesteckt ist und der zweite Teil des ersten Wellenlochs auf den zweiten Teil der ersten Drehwelle aufgesteckt ist.

5. Drehmechanismus (100) nach einem der Ansprüche 1 bis 3, wobei der Drehmechanismus ferner eine zweite Drehwelle (142) umfasst und die zweite Achse eine Achse der zweiten Drehwelle ist;
der zweite Drehsitz umfasst ein zweites Wellenloch, wobei das zweite Wellenloch in einer axialen Richtung einen ersten Teil und einen zweiten Teil umfasst, wobei der erste Teil des zweiten Wellenlochs entsprechend den zweiten Getriebezähnen angeordnet ist und eine Öffnung des ersten Teils des zweiten Wellenlochs kleiner ist als eine Öffnung des zweiten Teils des zweiten Wellenlochs; und
die zweite Drehwelle umfasst einen ersten Teil und einen zweiten Teil, wobei ein Durchmesser des ersten Teils der zweiten Drehwelle kleiner ist als ein Durchmesser des zweiten Teils der zweiten Drehwelle, wobei der erste Teil des zweiten Wellenlochs auf den ersten Teil der zweiten Drehwelle aufgesteckt ist und der zweite Teil des zweiten Wellenlochs auf den zweiten Teil der zweiten Drehwelle aufgesteckt ist.

6. Drehmechanismus (100) nach einem der Ansprüche 1 bis 3, wobei der Drehmechanismus ferner eine erste Drehwelle (141) umfasst und die erste Achse eine Achse der ersten Drehwelle ist; wobei ein Ende des ersten Drehsitzes (111) mit einer ersten Drehwelle versehen ist, die integral mit dem ersten Drehsitz ausgebildet ist, und das andere Ende des ersten Drehsitzes fest mit der ersten Drehwelle verbunden ist; und/oder der Drehmechanismus ferner eine zweite Drehwelle (142) umfasst und die zweite Achse eine Achse der zweiten Drehwelle ist; und wobei ein Ende des zweiten Drehsitzes mit einer zweiten Drehwelle versehen ist, die integral mit dem zweiten Drehsitz ausgebildet ist, und das andere Ende des zweiten Drehsitzes fest mit der zweiten Drehwelle verbunden ist.

7. Drehmechanismus (100) nach Anspruch 6, wobei sich der erste Stützrahmen (181) in einer ersten Richtung erstreckt, wobei die erste Richtung senkrecht zur ersten Achse verläuft und zwei Enden des ersten Stützrahmens in der ersten Richtung jeweils drehbar mit der ersten Drehwelle (141) und der zweiten Drehwelle (142) verbunden sind.

8. Drehmechanismus (100) nach einem der Ansprüche 1 bis 3, wobei zwei Enden des ersten Drehsitzes (111) jeweils mit einer ersten Drehwelle (1114) versehen sind, die einstückig mit dem ersten Drehsitz ausgebildet ist, und zwei Enden des zweiten Drehsitzes jeweils mit einer zweiten Drehwelle versehen sind, die einstückig mit dem zweiten Drehsitz ausgebildet ist;
der Drehmechanismus umfasst ferner eine erste Drehwelle (141), eine zweite Drehwelle (142), den ersten Stützrahmen (181) und einen zweiten Stützrahmen (183); wobei der erste Drehsitz (111), der zweite Drehsitz und der Zahnradsatz (130) zwischen dem ersten Stützrahmen und dem zweiten Stützrahmen angeordnet sind; wobei sich der erste Stützrahmen und der zweite Stützrahmen in einer ersten Richtung erstrecken, wobei die erste Richtung senkrecht zur ersten Achse verläuft, die erste Achse eine Achse der ersten Drehwelle ist und die zweite Achse eine Achse der zweiten Drehwelle ist;
wobei zwei Enden des ersten Stützrahmens in der ersten Richtung jeweils drehbar mit der ersten Drehwelle an einem Ende des ersten Drehsitzes und der zweiten Drehwelle an einem Ende des zweiten Drehsitzes verbunden sind; und
zwei Enden des zweiten Stützrahmens in der ersten Richtung jeweils mit einem ersten Durchgangsloch und einem zweiten Durchgangsloch versehen sind, wobei die erste Drehwelle am anderen Ende des ersten Drehsitzes und ein Ende der ersten Drehwelle im ersten Durchgangsloch angeordnet sind und die zweite Drehwelle am anderen Ende des zweiten Drehsitzes und ein Ende der zweiten Drehwelle im zweiten Durchgangsloch angeordnet sind.

9. Drehmechanismus (100) nach Anspruch 1, wobei zwei erste Nocken (112) am ersten Schwenkarm (110) in einem axialen Abstand voneinander angeordnet sind, zwei zweite Nocken am zweiten Schwenkarm (120) in einem axialen Abstand voneinander angeordnet sind und die ersten Nocken und die zweiten Nocken einander entsprechend angeordnet sind;
eine erste Nockenhalterung (151) und eine zweite Nockenhalterung (152) in axialem Abstand zwischen den beiden ersten Nocken angeordnet sind, wobei sich sowohl die erste Nockenhalterung als auch die zweite Nockenhalterung in einer ersten Richtung erstrecken und die erste Richtung senkrecht zur ersten Achse verläuft;
ein Ende der ersten Nockenhalterung und ein Ende der zweiten Nockenhalterung stehen jeweils in konkav-konvexer Passung mit den entsprechenden ersten Nocken, und das andere Ende der ersten Nockenhalterung sowie das andere Ende der zweiten Nockenhalterung stehen jeweils in konkav-konvexer Passung mit den entsprechenden zweiten Nocken;
der Drehmechanismus umfasst ferner eine erste Drehwelle (141) und eine zweite Drehwelle (142), wobei die erste Achse eine Achse der ersten Drehwelle ist und die zweite Achse eine Achse der zweiten Drehwelle ist;
ein Ende der ersten Drehwelle ist mit dem ersten Drehsitz (111) verbunden, und das andere Ende der ersten Drehwelle verläuft durch die ersten Nocken, ein Ende der ersten Nockenhalterung und ein Ende der zweiten Nockenhalterung;
ein Ende der zweiten Drehwelle ist mit dem zweiten Drehsitz verbunden, und das andere Ende der zweiten Drehwelle verläuft durch die zweiten Nocken, das andere Ende der ersten Nockenhalterung und das andere Ende der zweiten Nockenhalterung; und
Federn (160) sind sowohl auf der ersten Drehwelle als auch auf der zweiten Drehwelle angebracht, und die Federn befinden sich zwischen der ersten Nockenhalterung und der zweiten Nockenhalterung.

10. Drehmechanismus (100) nach Anspruch 1, wobei der erste Schwenkarm (110) mit einer ersten Nocke (112) versehen ist, der zweite Schwenkarm (120) mit einer zweiten Nocke versehen ist und die erste Nocke sowie die zweite Nocke entsprechend angeordnet sind;
der Drehmechanismus umfasst ferner eine erste Drehwelle (141), eine zweite Drehwelle (142), eine Nockenhalterung (152) und einen dritten Stützrahmen (182), wobei sowohl die Nockenhalterung als auch der dritte Stützrahmen sich in einer ersten Richtung erstrecken und in einer axialen Richtung beabstandet angeordnet sind, und wobei die erste Richtung senkrecht zur axialen Richtung verläuft;
ein Ende der Nockenhalterung steht in konkav-konvexer Passung mit der ersten Nocke, das andere Ende der Nockenhalterung steht in konkav-konvexer Passung mit der zweiten Nocke, eine von der Nockenhalterung in axialer Richtung abgewandte Seite des dritten Stützrahmens ist mit einer Sicherungsringhalterung (190) versehen, und die Sicherungsringhalterung erstreckt sich in der ersten Richtung;
ein Ende der ersten Drehwelle ist mit dem ersten Drehsitz (111) verbunden, und das andere Ende der ersten Drehwelle verläuft nacheinander durch die erste Nocke, ein Ende der Nockenhalterung, ein Ende des dritten Stützrahmens und ein Ende der Sicherungsringhalterung; ein Ende der zweiten Drehwelle ist mit dem zweiten Drehsitz verbunden, und das andere Ende der zweiten Drehwelle verläuft durch die zweite Nocke, das andere Ende der Nockenhalterung, das andere Ende des dritten Stützrahmens und das andere Ende der Sicherungsringhalterung; und Federn sind sowohl auf der ersten Drehwelle als auch auf der zweiten Drehwelle angebracht, und die Federn befinden sich zwischen der Nockenhalterung und dem dritten Stützrahmen.

11. Ein faltbares Endgerät (1), umfassend:
einen ersten Körper (200);
einen zweiten Körper (300); und
den Drehmechanismus (100) nach einem der Ansprüche 1 bis 10, wobei der erste Schwingarm (110) im Drehmechanismus mit dem ersten Körper verbunden ist und der zweite Schwingarm (120) im Drehmechanismus mit dem zweiten Körper verbunden ist.

12. Das faltbare Endgerät (1) nach Anspruch 11, ferner umfassend: einen flexiblen Bildschirm (400), wobei der flexible Bildschirm den ersten Körper (200), den zweiten Körper (300) und den Drehmechanismus (100) abdeckt.

## Revendications

1. Un mécanisme rotatif (100), comprenant :
un premier bras oscillant (110), pourvu d'un premier siège rotatif (111), le premier bras oscillant étant capable de pivoter autour d'un premier axe (L1), dans lequel le premier bras oscillant est pourvu d'une première came (112), la première came et le premier siège rotatif étant espacés l'un de l'autre dans une direction axiale ;
un second bras oscillant (120), pourvu d'un second siège rotatif (121), le second bras oscillant étant capable de pivoter autour d'un second axe (L2), et le second axe étant parallèle au premier axe, dans lequel le second bras oscillant est pourvu d'une seconde came, la seconde came et le second siège rotatif étant espacés l'un de l'autre dans la direction axiale, la première came et la seconde came étant disposées de manière correspondante ; et
un support de came (151), une extrémité du support de came est en ajustement concave-convexe avec la première came, l'autre extrémité du support de came est en ajustement concave-convexe avec la seconde came ; dans lequel
le premier siège rotatif est pourvu d'une pluralité de premières dents d'engrenage (1111) réparties dans une direction circonférentielle, le second siège rotatif est pourvu d'une pluralité de secondes dents d'engrenage (1211) réparties dans une direction circonférentielle, et la pluralité de premières dents d'engrenage et la pluralité de secondes dents d'engrenage sont engrenées et connectées par l'intermédiaire d'un ensemble d'engrenages (130), pour permettre au premier bras oscillant et au second bras oscillant de pivoter de manière synchrone et inverse,
**caractérisé en ce que** le mécanisme rotatif comprend en outre un premier support de fixation (171) et un premier cadre de support (181), le premier cadre de support et le premier support de fixation sont espacés sur deux côtés de l'ensemble d'engrenages dans la direction axiale, une première extrémité de l'ensemble d'engrenages est connectée de manière rotative au premier cadre de support et une seconde extrémité de l'ensemble d'engrenages est connectée de manière rotative au premier support de fixation.

2. Le mécanisme rotatif (100) selon la revendication 1, dans lequel une partie du premier siège rotatif (111) s'étendant dans la direction circonférentielle est pourvue de la pluralité de premières dents d'engrenage (1111), et une partie du second siège rotatif (121) s'étendant dans la direction circonférentielle est pourvue de la pluralité de secondes dents d'engrenage (1211).

3. Le mécanisme rotatif selon la revendication 1, dans lequel l'ensemble d'engrenages (130) comprend un premier engrenage (131) et un second engrenage (132), le premier engrenage est engrené séparément avec les premières dents d'engrenage (1111) et le second engrenage, et le second engrenage est engrené séparément avec le premier engrenage et les secondes dents d'engrenage (1211).

4. Le mécanisme rotatif (100) selon l'une quelconque des revendications 1 à 3, dans lequel le mécanisme rotatif comprend en outre un premier arbre rotatif (141), et le premier axe est un axe du premier arbre rotatif ;
le premier siège rotatif (111) comprend un premier trou d'arbre (1112a), le premier trou d'arbre comprend une première partie (11121) et une seconde partie (11122) dans une direction axiale, la première partie du premier trou d'arbre est agencée de manière correspondante aux premières dents d'engrenage (1111), et une ouverture de la première partie du premier trou d'arbre est plus petite qu'une ouverture de la seconde partie du premier trou d'arbre ; et
le premier arbre rotatif comprend une première partie (1411) et une seconde partie (1412), un diamètre de la première partie du premier arbre rotatif est plus petit qu'un diamètre de la seconde partie du premier arbre rotatif, la première partie du premier trou d'arbre est emmanchée sur la première partie du premier arbre rotatif, et la seconde partie du premier trou d'arbre est emmanchée sur la seconde partie du premier arbre rotatif.

5. Le mécanisme rotatif (100) selon l'une quelconque des revendications 1 à 3, dans lequel le mécanisme rotatif comprend en outre un second arbre rotatif (142), et le second axe est un axe du second arbre rotatif ;
le second siège rotatif comprend un second trou d'arbre, le second trou d'arbre comprend une première partie et une seconde partie dans une direction axiale, la première partie du second trou d'arbre est agencée de manière correspondante aux secondes dents d'engrenage, et une ouverture de la première partie du second trou d'arbre est plus petite qu'une ouverture de la seconde partie du second trou d'arbre ; et
le second arbre rotatif comprend une première partie et une seconde partie, un diamètre de la première partie du second arbre rotatif est plus petit qu'un diamètre de la seconde partie du second arbre rotatif, la première partie du second trou d'arbre est emmanchée sur la première partie du second arbre rotatif, et la seconde partie du second trou d'arbre est emmanchée sur la seconde partie du second arbre rotatif.

6. Le mécanisme rotatif (100) selon l'une quelconque des revendications 1 à 3, dans lequel le mécanisme rotatif comprend en outre un premier arbre rotatif (141), et le premier axe est un axe du premier arbre rotatif ; une extrémité du premier siège rotatif (111) est munie d'un premier arbre rotatif formé intégralement avec le premier siège rotatif, et l'autre extrémité du premier siège rotatif est reliée de manière fixe au premier arbre rotatif ; et/ou, le mécanisme rotatif comprend en outre un second arbre rotatif (142), et le second axe est un axe du second arbre rotatif ; et une extrémité du second siège rotatif est munie d'un second arbre rotatif formé intégralement avec le second siège rotatif, et l'autre extrémité du second siège rotatif est reliée de manière fixe au second arbre rotatif.

7. Mécanisme rotatif (100) selon la revendication 6, dans lequel le premier cadre de support (181) s'étend dans une première direction, ladite première direction étant perpendiculaire au premier axe, et les deux extrémités du premier cadre de support dans la première direction sont reliées de manière rotative au premier arbre rotatif (141) et au second arbre rotatif (142), respectivement.

8. Mécanisme rotatif (100) selon l'une quelconque des revendications 1 à 3, dans lequel les deux extrémités du premier siège rotatif (111) sont chacune pourvues d'un premier arbre rotatif (1114) formé d'une seule pièce avec le premier siège rotatif, et les deux extrémités du second siège rotatif sont chacune pourvues d'un second arbre rotatif formé d'une seule pièce avec le second siège rotatif ;
le mécanisme rotatif comprend en outre un premier arbre rotatif (141), un second arbre rotatif (142), le premier cadre de support (181) et un second cadre de support (183) ; le premier siège rotatif (111), le second siège rotatif et l'ensemble d'engrenages (130) sont disposés entre le premier cadre de support et le second cadre de support ; le premier cadre de support et le second cadre de support s'étendent dans une première direction, ladite première direction est perpendiculaire au premier axe, le premier axe est un axe du premier arbre rotatif, et le second axe est un axe du second arbre rotatif ;
les deux extrémités du premier cadre de support dans la première direction sont reliées de manière rotative au premier arbre rotatif situé à une extrémité du premier siège rotatif et au second arbre rotatif situé à une extrémité du second siège rotatif, respectivement ; et
les deux extrémités du second cadre de support dans la première direction sont pourvues respectivement d'un premier trou traversant et d'un second trou traversant, le premier arbre rotatif situé à l'autre extrémité du premier siège rotatif et une extrémité du premier arbre rotatif sont disposés dans le premier trou traversant, et le second arbre rotatif situé à l'autre extrémité du second siège rotatif et une extrémité du second arbre rotatif sont disposés dans le second trou traversant.

9. Mécanisme rotatif (100) selon la revendication 1, dans lequel deux premières cames (112) sont disposées sur le premier bras oscillant (110) à un intervalle dans une direction axiale, deux secondes cames sont disposées sur le second bras oscillant (120) à un intervalle dans la direction axiale, et les premières cames et les secondes cames sont agencées de manière correspondante ;
un premier support de came (151) et un second support de came (152) sont disposés à un intervalle dans la direction axiale entre les deux premières cames, le premier support de came et le second support de came s'étendent tous deux dans une première direction, et la première direction est perpendiculaire au premier axe ;
une extrémité du premier support de came et une extrémité du second support de came sont respectivement en ajustement concave-convexe avec les premières cames correspondantes, et l'autre extrémité du premier support de came et l'autre extrémité du second support de came sont respectivement en ajustement concave-convexe avec les secondes cames correspondantes ;
le mécanisme rotatif comprend en outre un premier arbre rotatif (141) et un second arbre rotatif (142), le premier axe est un axe du premier arbre rotatif, et le second axe est un axe du second arbre rotatif ;
une extrémité du premier arbre rotatif est reliée au premier siège rotatif (111), et l'autre extrémité du premier arbre rotatif passe à travers les premières cames, une extrémité du premier support de came et une extrémité du second support de came ;
une extrémité du second arbre rotatif est reliée au second siège rotatif, et l'autre extrémité du second arbre rotatif passe à travers les secondes cames, l'autre extrémité du premier support de came et l'autre extrémité du second support de came ; et
des ressorts (160) sont manchonnés sur le premier arbre rotatif et le second arbre rotatif, et les ressorts sont situés entre le premier support de came et le second support de came.

10. Le mécanisme rotatif (100) selon la revendication 1, dans lequel le premier bras oscillant (110) est pourvu d'une première came (112), le second bras oscillant (120) est pourvu d'une seconde came, et la première came et la seconde came sont agencées de manière correspondante ;
le mécanisme rotatif comprend en outre un premier arbre rotatif (141), un second arbre rotatif (142), un support de came (152) et un troisième cadre de support (182), le support de came et le troisième cadre de support s'étendent tous deux dans une première direction et sont agencés à un intervalle dans une direction axiale, et la première direction est perpendiculaire à la direction axiale ;
une extrémité du support de came est en ajustement concave-convexe avec la première came, l'autre extrémité du support de came est en ajustement concave-convexe avec la seconde came, un côté du troisième cadre de support éloigné du support de came dans la direction axiale est pourvu d'un support de circlip (190), et le support de circlip s'étend dans la première direction ;
une extrémité du premier arbre rotatif est reliée au premier siège rotatif (111), et l'autre extrémité du premier arbre rotatif passe séquentiellement à travers la première came, une extrémité du support de came, une extrémité du troisième cadre de support et une extrémité du support de circlip ; une extrémité du second arbre rotatif est reliée au second siège rotatif, et l'autre extrémité du second arbre rotatif passe à travers la seconde came, l'autre extrémité du support de came, l'autre extrémité du troisième cadre de support et l'autre extrémité du support de circlip ; et des ressorts sont manchonnés sur le premier arbre rotatif et le second arbre rotatif, et les ressorts sont situés entre le support de came et le troisième cadre de support.

11. Un terminal pliable (1), comprenant :
un premier corps (200) ;
un second corps (300) ; et
le mécanisme rotatif (100) selon l'une quelconque des revendications 1 à 10, dans lequel le premier bras oscillant (110) dans le mécanisme rotatif est relié au premier corps, et le second bras oscillant (120) dans le mécanisme rotatif est relié au second corps.

12. Le terminal pliable (1) selon la revendication 11, comprenant en outre : un écran flexible (400), dans lequel l'écran flexible recouvre le premier corps (200), le second corps (300) et le mécanisme rotatif (100).
